# EUROPÄISCHE PATENTSCHRIFT

(11) **EP 2 684 223 B1**
(45) Veröffentlichungstag und Bekanntmachung des Hinweises auf die Patenterteilung: **22.01.2020**
(21) Anmeldenummer: 12712062.4
(22) Anmeldetag: 05.03.2012
(51) Int. Cl.: H01L 33/48, H01L 33/64

(54) **GEHÄUSE FÜR HOCHLEISTUNGSLEUCHTDIODEN**
HOUSING FOR HIGH-POWER LIGHT-EMITTING DIODES
BOÎTIER POUR DIODES LUMINESCENTES HAUTE PUISSANCE

(30) Priorität: 07.03.2011 DE 102011013277
(43) Veröffentlichungstag der Anmeldung: 15.01.2014
(73) Patentinhaber: Schott AG, 55122 Mainz (DE)
(72) Erfinder: HETTLER, Robert, 84036 Kumhausen (DE); RINDT, Matthias, 84028 Landshut (DE)
(74) Vertreter: Blumbach · Zinngrebe Patentanwälte PartG mbB
(86) Internationale Anmeldenummer: PCT/EP2012/000974
(87) Internationale Veröffentlichungsnummer: WO 2012/119749

(56) Entgegenhaltungen:
- WO-A1-2009/132838
- JP-A- 2002 223 007
- US-A- 4 742 432
- US-A1- 2002 113 244
- US-A1- 2006 169 999
- US-A1- 2006 245 195

## Beschreibung

### Beschreibung der Erfindung

Die vorliegende Erfindung betrifft ein Gehäuse für opto-elektronische Bauteile, wie LEDs, und ein Verfahren zur Herstellung des genannten Gehäuses.

### Hintergrund der Erfindung

Als allgemeiner Standard werden heutzutage sogenannte "High Power Light Emitting Diodes" (LED) in Kunststoff- und Harz-Konstruktionen, d.h. in organischen Gehäusen verkapselt. Jedoch ist eine in einem solchen Gehäuse positionierte LED nicht ausreichend hermetisch verkapselt gegenüber möglichen Einflüssen durch die Umgebung. Das kann zur Degradation von Materialien, Oberflächen und/oder elektrischen Verbindungen führen. Zudem erweist sich die thermische Stabilität des Harzes für opto-elektronische Bauteile mit einem höheren Output, z.B. 5 W-LEDs, als problematisch.

Eine Technologie zur Überwindung dieser Nachteile ist in der Patentanmeldung WO 2009/132838 A1 beschrieben. Dort ist ein im Wesentlichen vollständiges anorganisches Gehäuse beschrieben. Es ist ein Gehäuse, das einen Verbund aus einem metallischen Basisteil und einem metallischen Kopfteil, das auf der Oberseite des Basisteils angeordnet ist, umfasst. Diese sind über eine Glasschicht miteinander verbunden. Auf dem Basisteil wird ein opto-elektronisches Funktionselement positioniert. Das Kopfteil bildet über dem Basisteil unter anderem einen Reflektor für die von dem opto-elektronischen Funktionselement emittierte Strahlung oder zu empfangende Strahlung. Bei dem Zusammenfügen des Basisteils, der Glasschicht und des Kopfteils wird die Glasschicht insoweit erwärmt, dass das Glas eine Viskosität erreicht, bei der das Glas anhaftet und das Basisteil und das Kopfteil mittels der ersten Glasschicht einen Verbund bilden. Das dort beschriebene Gehäuse hat sich als sehr vorteilhaft erwiesen. Insbesondere die Glasverbindung ermöglicht das Herstellen einer hermetischen Verkapselung mit erhöhter Temperaturbeständigkeit. Mit der Technologie ist es möglich, kleine Gehäuse mit den genannten Vorteilen kostengünstig herzustellen.

Gehäuse für optoelektronische Bauelemente sind ferner aus den Dokumenten US 4 742 423, A JP 2002 223007 A, US 2006/169999 A1, US 2006/245195 A1 und US 2002/113244 A1 bekannt.

Insbesondere zeigt das Dokument US 2O06/245195 A1 ein Gehäuse mit einem Reflektor.

### Allgemeine Beschreibung der Erfindung

Vor dem vorstehend geschilderten Hintergrund liegt der vorliegenden Erfindung die Aufgabe zugrunde, ein alternatives Gehäuse für optoelektronische Bauelemente, insbesondere für LEDs mit einer hohen Leistung, und ein alternatives Verfahren zur Herstellung eines solchen Gehäuses bereitzustellen.

Insbesondere soll es auch möglich sein, ein kompaktes Gehäuse mit kleinen Abmessungen bereitstellen zu können.

Gelöst werden diese Aufgaben bereits durch das Gehäuse zur Aufnahme eines opto-elektronischen Funktionselements sowie durch das Verfahren zur Herstellung eines solchen Gehäuses gemäß den unabhängigen Patentansprüchen. Vorteilhafte Ausführungsformen des erfindungsgemäßen Gehäuses und des erfindungsgemäßen Verfahrens sind Gegenstand der jeweiligen Unteransprüche.

Die vorliegende Erfindung sieht ein Gehäuse zur Aufnahme eines opto-elektronischen Funktionselements, insbesondere einer LED, vor, welches zumindest aus den folgenden Bestandteilen aufgebaut ist oder aus den folgenden Bestandteilen besteht. Das erfindungsgemäße Gehäuse ist ein Gehäuse aus
- einem Basiskörper mit einer Oberseite, die zumindest abschnittsweise einen Montagebereich für wenigstens ein opto-elektronisches Funktionselement definiert, so dass der Basiskörper einen Kühlkörper für wenigstens ein opto-elektronisches Funktionselement bildet, einer Unterseite und einem Mantel; und
- wenigstens einem Anschlusskörper für wenigstens ein opto-elektronisches Funktionselement, welcher zumindest mittels einer Glasschicht mit dem Basiskörper, vorzugsweise stoffschlüssig, verbunden ist,
- wobei der wenigstens eine Anschlusskörper mantelseitig an dem Basiskörper angeordnet und/oder befestigt ist und sich zumindest abschnittsweise, vorzugsweise entlang des Basiskörpermantels, über den Umfang des Basiskörpers erstreckt und/oder
- wobei zumindest die Oberseite des Basiskörpers wenigstens eine erste Vertiefung mit einem Boden, welcher den Montagebereich für zumindest ein opto-elektronisches Funktionselement bereitstellt, aufweist,
- wobei der Basiskörper eine Oberseite und eine Unterseite aufweist, wobei ein Mantel des Basiskörpers eine seitliche Wand beschreibt, welche die Oberseite mit der Unterseite verbindet,
wobei die Oberseite des Basiskörpers wenigstens eine zweite Vertiefung aufweist, die sich zumindest abschnittsweise über den Umfang der ersten Vertiefung erstreckt, so dass der Mantel des Basiskörpers zumindest durch einen äußeren Mantel und einen inneren Mantel gebildet wird,
wobei eine Innenseite des Durchgangsbereichs des Anschlusskörpers an den inneren Mantel des Basiskörpers angrenzt,
und wobei die zweite Vertiefung einen Aufnahmebereich für den Anschlusskörper bereitstellt.

Weiterhin erstreckt sich die Erfindung auf ein Verfahren zur Herstellung eines opto-elektronischen Funktionselementgehäuses, insbesondere für eine LED, umfassend die folgenden Verfahrensschritte:
- Bereitstellen wenigstens eines Basiskörpers mit einer Oberseite, welche zumindest abschnittsweise einen Montagebereich für wenigstens ein opto-elektronisches Funktionselement definiert, so dass der Basiskörper einen Kühlkörper für wenigstens ein opto-elektronisches Funktionselement bildet,
- Bereitstellen wenigstens eines Anschlusskörpers für wenigstens ein opto-elektronisches Funktionselement und zumindest eines Glases zwischen dem Basiskörper und dem Anschlusskörper zum Verbinden des Anschlusskörpers mit dem Basiskörper,
- Zusammenfügen des Basiskörpers, des Anschlusskörpers und des Glases und
- Erwärmen des Glases insoweit, dass dieses eine Viskosität besitzt und/oder erreicht, bei der es anhaftet und aus dem Basiskörper und dem Anschlusskörper ein Verbund bildbar ist,
- Abkühlen des Glases, so dass der Basiskörper und der Anschlusskörper zumindest mittels einer aus dem abgekühlten Glas gebildeten Glasschicht einen stoffschlüssigen Verbund bilden,
- wobei der Anschlusskörper zumindest abschnittsweise an einem Mantel des Basiskörpers befestigt wird, indem das Glas zumindest abschnittsweise zwischen dem Mantel des Basiskörpers und dem Anschlusskörper bereitgestellt wird, und/oder
- wobei zumindest in der Oberseite des Basiskörpers wenigstens eine erste Vertiefung mit einem Boden, der den Montagebereich für zumindest ein opto-elektronisches Funktionselement bereitstellt, eingebracht wird,
wobei der Basiskörper eine Oberseite und eine Unterseite aufweist, wobei ein Mantel des Basiskörpers eine seitliche Wand beschreibt, welche die Oberseite mit der Unterseite verbindet,
wobei die Oberseite des Basiskörpers wenigstens eine zweite Vertiefung aufweist, die sich zumindest abschnittsweise über den Umfang der ersten Vertiefung erstreckt, so dass der Mantel des Basiskörpers zumindest durch einen äußeren Mantel und einen inneren Mantel gebildet wird,
wobei eine Innenseite des Durchgangsbereichs des Anschlusskörpers an den inneren Mantel des Basiskörpers angrenzt,
und wobei die zweite Vertiefung einen Aufnahmebereich für den Anschlusskörper bereitstellt.

In einer bevorzugten Ausgestaltung des Verfahrens wird bzw. werden der Basiskörper der Anschlusskörper und/oder die Glasschicht oder das die Glasschicht bildende Glas jeweils in einer Matrix bereitgestellt. Das erfindungsgemäße Gehäuse ist insbesondere herstellbar oder hergestellt mit dem erfindungsgemäßen Verfahren. Das erfindungsgemäße Verfahren ist vorzugsweise ausgebildet zur Herstellung des erfindungsgemäßen Gehäuses. Die Reihenfolge der einzelnen Verfahrensschritte kann variieren.

Entsprechend der Erfindung ist das erfindungsgemäße Gehäuse ein im Wesentlichen anorganisches Gehäuse. Es besteht aus oder umfasst einen Basiskörper aus Metall, einen Anschlusskörper aus Metall und die Glasschicht.

Das wenigstens eine Funktionselement wird bzw. ist auf dem Basiskörper angeordnet. Der Basiskörper stellt zum einen das tragende Element für das Funktionselement dar. Der Basiskörper kann somit auch als Träger oder Grundkörper bezeichnet werden. Zum anderen stellt der Basiskörper den Kühlkörper für das Funktionselement dar.

Der Basiskörper kann einteilig oder segmentiert ausgebildet sein und zum Beispiel aus Lagen aufgebaut sein. Es können zudem auch Durchgangsleitungen, sogenannte thermische Vias, in dem Basiskörper eingebracht sein. Das Funktionselement ist nach dem Einbau in das Gehäuse bzw. nach dem Aufsetzen auf dem Basiskörper in einem direkten Kontakt mit dem Basiskörper.

Das Funktionselement kann zum Beispiel auf dem Basiskörper aufgeklebt und/oder aufgelötet werden. Als Lote werden vorzugsweise bleifreie Weichlote verwendet. Der Kleber ist vorzugsweise ein leitfähiger Kleber, wie ein mit Silber angereicherter Epoxidharz. Somit wird über einen direkten Kontakt auch ein Kontakt über einen Kleber, Lot oder ein Bindemittel verstanden.

Da der Basiskörper erfindungsgemäß auch einen Kühlkörper für das Funktionselement darstellt, umfasst er Materialien, welche eine entsprechende Leitfähigkeit für Wärme besitzen. Vorzugsweise hat der Basiskörper eine Wärmeleitfähigkeit von zumindest etwa 50 W/mK, vorzugsweise von zumindest etwa 150 W/mK.

Der Basiskörper ist thermisch anschließbar an weitere Bauteile. Vorzugsweise umfasst der Basiskörper wenigstens ein Metall oder besteht aus einem Metall oder einer Legierung. Ein gängiges Metall ist zum Beispiel Kupfer und/oder Aluminium und/oder Nickel und/oder Eisen und/oder Molybdän und/oder Kupfer-Wolfram und/oder Cu-Molybdän.

Im Allgemeinen hat der Basiskörper in einer Aufsicht auf seine Oberseite eine Fläche von etwa 9 mm² bis etwa 400 mm², vorzugsweise bis etwa 50 mm². Seine Höhe liegt im Allgemeinen bei etwa 0,1 mm bis etwa 10 mm, vorzugsweise bis etwa 2 mm.

Der Montagebereich für das wenigstens eine Funktionselement liegt im Allgemeinen im Mittelpunkt der ersten Vertiefung. Falls nur ein Funktionselement in dem Gehäuse untergebracht werden soll, befindet sich der Montagebereich im Bereich der Mittelachse oder auf der Mittelachse des Basiskörpers.

Das Funktionselement wird in der ersten Vertiefung des Basiskörpers positioniert. Der Querschnitt der Vertiefung ist abhängig von der Größe des Funktionselements und/oder von der Anzahl der Funktionselemente, die in der ersten Vertiefung untergebracht werden sollen, und/oder von der Anzahl der ersten Vertiefungen in dem Basiskörper. Die erste Vertiefung kann in einer Aufsicht auf die Oberseite des Basiskörpers eine Fläche von etwa 4 mm² bis etwa 1000 mm² oder etwa 4 mm² bis etwa 50 mm², vorzugsweise bis etwa 20 mm², besitzen. Deren Tiefe ist im Allgemeinen so gewählt, dass das in der ersten Vertiefung positionierte Funktionselement im Wesentlichen vollständig in die erste Vertiefung eintauchen kann. Die Tiefe der ersten Vertiefung liegt im Allgemeinen bei etwa 0,2 mm bis etwa 2 mm.

In einer Ausführungsform besitzt die erste Vertiefung einen Durchmesser, der ausgehend vom Boden der ersten Vertiefung, auf dem wenigstens ein opto-elektronisches Funktionselement positionierbar ist, in Richtung der Oberseite der ersten Vertiefung zunimmt. Die erste Vertiefung kann zumindest abschnittsweise die Gestalt eines Kegelstumpfs oder eines Pyramidenstumpfs annehmen. Durch diese Ausgestaltung kann die Abstrahlungs- und/oder die Empfangscharakteristik des Gehäuses für Licht oder allgemein für Strahlung verbessert werden.

Vorzugsweise hat dazu eine Innenseite oder der Mantel der ersten Vertiefung in dem Basiskörper und/oder zusätzlich auch eine Innenseite eines Durchgangsbereichs in dem Anschlusskörper, der noch nachfolgend erläutert wird, zumindest abschnittsweise reflektierende Eigenschaften. Durch die erste Vertiefung in der Oberseite des Basiskörpers und/oder durch den genannten Durchgangsbereich in dem Anschlusskörper kann ein Reflektor für die von einem opto-elektronischen emittierte und/oder zu empfangende Strahlung gebildet werden.

Der wenigstens eine Anschlusskörper ist ein Anschlusskörper zum Bereitstellen eines elektrischen Anschlusses für das auf der Oberseite, vorzugsweise in der ersten Vertiefung, des Basiskörpers positionierte Funktionselement. Über den Anschlusskörper kann im Allgemeinen eine Verbindung der Oberseite des Basiskörpers und somit des Funktionselements mit der Umgebung hergestellt werden.

Der Anschlusskörper ist ein massiver Körper. Insbesondere ist er ebenfalls eine metallische Platte. Vorzugsweise kann dieser auch unter leichtem Druck, beispielsweise durch ein Pressen mit den Fingern, verformbar sein. Dieser stellt keine auf dem Basiskörper, zum Beispiel mittels eines PVD-Verfahrens, aufgebrachte oder aufgewachsene Schicht dar.

Der Anschlusskörper ist von dem Basiskörper elektrisch isoliert. Er ist zumindest abschnittsweise durch die Glasschicht getrennt und/oder zumindest abschnittsweise beabstandet von dem Basiskörper angeordnet.

Der Anschlusskörper umfasst oder ist ein Metall oder eine Legierung. Das Metall ist hierbei zumindest ein Mitglied ausgewählt aus der Gruppe von Kupfer, Aluminium, Nickel, Cobalt, Eisen, Stahl oder Edelstahl, ferritischen Stahl oder Edelstahl und austenitischen Stahl oder Edelstahl. Im Allgemeinen hat der Anschlusskörper in einer Aufsicht auf seine Oberseite eine Fläche von etwa 9 mm² bis etwa 1000 mm², vorzugsweise bis etwa 50 mm². Seine Höhe liegt im Allgemeinen bei etwa 0,1 mm bis etwa 5 mm, vorzugsweise bis etwa 2 mm.

Entsprechend der Erfindung stellt der Anschlusskörper einen Durchgangsbereich für eine von zumindest einem opto-elektronischen Funktionselement emittierte und/oder zu empfangende Strahlung bereit. Der Durchgangsbereich erstreckt sich zumindest abschnittsweise über den Umfang der ersten Vertiefung und/oder über den Montagebereich für zumindest ein opto-elektronisches Funktionselement und/oder über den Basiskörper. Der Durchgangsbereich kann einen Bereich beschreiben, durch den Licht oder Strahlung passieren und somit ein- und/oder austreten kann. Der Durchgangsbereich ist vorzugsweise als eine Aussparung oder ein Loch in dem Anschlusskörper ausgeführt. Das Licht kann dabei auf die Mantelfläche der Aussparung fallen.

Vorzugsweise ist der Durchgangsbereich koaxial zum Basiskörper und/oder zur ersten Vertiefung angeordnet. Der Durchgangsbereich kann in einer Aufsicht auf die Oberseite des Basiskörpers eine Fläche von etwa 4 mm² bis etwa 1000 mm² oder etwa 4 mm² bis etwa 50 mm², vorzugsweise bis etwa 20 mm², besitzen. Die Tiefe entspricht im Wesentlichen der Höhe des Anschlusskörpers.

Entsprechend der Erfindung weist die Oberseite des Gehäuses des Basiskörpers eine zweite Vertiefung auf, die sich zumindest abschnittsweise über den Umfang der ersten Vertiefung erstreckt, so dass der Mantel des Basiskörpers zumindest durch einen, vorzugsweise unteren, äußeren oder außen liegenden Mantel und einen, vorzugsweise oberen, inneren oder innen liegenden Mantel gebildet wird. Es wird sozusagen eine Art Stufe in dem Basiskörper oder in der Oberseite des Basiskörpers gebildet. Der äußere Mantel des Basiskörpers entspricht vorzugsweise dem eigentlichen Mantel des Basiskörpers. Der äußere Mantel liegt in einem größeren Abstand zum Mittelpunkt der ersten Vertiefung oder des Basiskörpers als der innere Mantel. Der Basiskörper hat eine Oberseite und eine Unterseite. Der Mantel beschreibt hierbei die seitliche Wand, welche die Oberseite mit der Unterseite verbindet.

Die zweite Vertiefung stellt einen Aufnahmebereich für den Anschlusskörper bereit. Der Anschlusskörper liegt zumindest abschnittsweise, insbesondere mit seiner Unterseite, auf dem Boden der zweiten Vertiefung auf. Der Anschlusskörper kann alternativ oder ergänzend an dem inneren und/oder äußeren Mantel des Basiskörpers angrenzen. Insbesondere grenzt dabei der Mantel des Anschlusskörpers, insbesondere der Mantel des Durchgangsbereichs, an den inneren und/oder äußeren Mantel des Basiskörpers an. Der Anschlusskörper ist folglich zumindest abschnittsweise auf der Oberseite des Basiskörpers angeordnet und/oder eine Innenseite des Durchgangsbereichs ist an dem inneren Mantel und/oder an dem äußeren Mantel des Basiskörpers angrenzend angeordnet.

Im Allgemeinen liegt die Breite der zweiten Vertiefung in einer Aufsicht auf die Oberseite des Basiskörpers in einem Bereich von etwa 0,5 mm bis etwa 15 mm, vorzugsweise bis etwa 6 mm. Die Breite der Vertiefung wird gegeben durch die Auflagefläche für den Anschlusskörper auf dem Basiskörper. Die Tiefe der zweiten Vertiefung liegt im Allgemeinen bei etwa 0,1 mm bis etwa 5 mm.

Da der Basiskörper und der Anschlusskörper im Allgemeinen zueinander elektrisch isoliert sind, wird auch unter einer angrenzenden Positionierung eine Positionierung verstanden, bei welcher der Basiskörper und der Anschlusskörper durch eine Glasschicht voneinander getrennt sind. In der zuerst genannten Ausführungsform ist die Glasschicht zumindest abschnittsweise zwischen einem Boden der zweiten Vertiefung und der Unterseite des Anschlusskörpers angeordnet ist. In der zweiten Ausführungsform ist die Glasschicht zumindest abschnittsweise zwischen dem inneren Rand des Anschlusskörpers, vorzugsweise des Durchgangsbereichs, und dem äußeren Rand des Basiskörpers angeordnet.

In einer weiteren Ausführungsform ist der Anschlusskörper segmentiert ausgeführt. Durch die gebildeten Segmente ist eine Vielzahl von Anschlüssen für eine Vielzahl von opto-elektronischen Funktionselementen oder für ein einzelnes auf dem Basiskörper positioniertes opto-elektronisches Funktionselement bereitstellbar. Vorzugsweise sind die Segmente des Anschlusskörpers voneinander beabstandet und/oder durch die Glasschicht elektrisch isoliert.

Eine weitere Ausgestaltung des Gehäuses ist derart, dass der Anschlusskörper sich zumindest abschnittsweise über den Basiskörper (hinaus erstreckt und wenigstens eine Lasche zum Verbinden bereitstellt. Die Lasche ist vorzugsweise manuell biegbar und/oder besitzt eine Breite, die, insbesondere kontinuierlich, radial nach außen hin abnimmt. Durch die Lasche vergrößert sich der Anschlusskörper. Im Allgemeinen hat der Anschlusskörper dann in einer Aufsicht auf seine Oberseite eine Fläche von etwa 9 mm² bis etwa 800 mm², vorzugsweise bis etwa 100 mm².

Weiterhin kann in oder an dem Basiskörper und/oder in oder an dem Anschlusskörper noch ein Montagebereich für ein Verbindungsmittel, vorzugsweise für einen Bonddraht, bereitgestellt werden. Der Montagebereich ist vorzugsweise als eine Aussparung in dem inneren Rand der ersten Vertiefung und/oder des Durchgangsbereichs ausgeführt.

Das Glas ist ein Glas zum Verbinden des Basiskörpers mit dem Anschlusskörper und/oder zum Isolieren des Basiskörpers von dem Anschlusskörper. Das Glas besitzt einen Erweichungspunkt oder eine Erweichungstemperatur in einem Bereich, der unterhalb der Schmelztemperatur der Materialien liegt, die für den Basiskörper und/oder den Anschlusskörper verwendet werden. Das Glas wird für das Verbinden oder ist beim Verbinden insoweit erwärmt, dass dass es eine Viskosität besitzt, bei der die Bauteile aneinander haften. Vorzugsweise besitzt das Glas beim Verbinden eine Viskosität in einem Bereich von 10⁷ Pas bis etwa 10³ Pas. Die Erwärmung erfolgt zum Beispiel in einem Ofen. Vorzugsweise ist oder umfasst das verwendete Glas ein Phosphatglas und/oder ein Weichglas und/oder einer Alkali-Titan-Silikat-Glas. Beispiele für ein Phosphatglas sind die Gläser mit der Bezeichnung SCHOTT G018-122. Beispiele für ein Weichglas sind die Gläser mit der Bezeichnung SCHOTT 8061 und/oder SCHOTT 8421.

Werden z.B. der Basiskörper und/oder der Anschlusskörper im Wesentlichen durch Kupfer und/oder Aluminium, insbesondere an der Grenzfläche zu dem Glas, bereitgestellt, so ist das Glas vorzugsweise ein Alkali-Titan-Silikat-Glas. Der Basiskörper und/oder der Anschlusskörper und/oder zumindest die Grenzflächen besitzt bzw. besitzen einen Anteil an Kupfer oder Aluminium von mindestens 50 Gew.%, vorzugsweise von mindestens 80 Gew.%.

In einer Ausführungsform besitzt oder umfasst das Alkali-Titan-Silikat- Glas die folgende Zusammensetzung (in Gewichtsprozent):

| | |
|---|---|
| SiO₂ | 20-50 |
| TiO₂ | 10-35 |
| R₂0 | 10-40 |
| | |
| | |
| | |
| Al₂O₃ | 0-5 |
| | |
| | |
| CaO+SrO | 0-5 |
| P₂O₅ | 0-5 |
| V₂O₅ | 0-5 |
| B₂O₃ | 0-5 |
| | |
| Sb₂O₃ | 0-1 |
| SnO₂ | 0-5 |
| Fe₂O₃ | < 1 |
| CoO | < 1 |
| NiO | < 1 |
| | |
| | |
| | |
| ZnO | 0-4 |
| ZrO₂ | 0-4 |
| F | 0-2 |
| MoO₃ | 0-1 |
| N₂O₅ | 0-6 |
| | |
| SO₃ | 0-1 |

Die in der Tabelle verwendete Bezeichnung R₂0 stellt die Summe aller Alkali-Oxide dar. Dabei sind die Alkalimetalle wenigstens bereitgestellt durch die Elemente Li, Na und K.

In einer konkreten Ausführungsform umfasst die Gruppe R₂0 die folgenden Bestandteile (in Gewichtsprozent):

| | |
|---|---|
| Na₂O | 11 - 22 |
| K₂O | 8 - 17 |
| Li₂O | 0,2 - 3 |

In einer ersten bevorzugten Ausführungsform besitzt oder umfasst das Glas die folgende Zusammensetzung:

| | |
|---|---|
| SiO₂ | 26 - 30 |
| TiO₂ | 21 - 25 |
| | |
| Na₂O | 14 - 18 |
| K₂O | 11 - 15 |
| Li₂O | > 0 - 3 |
| Al₂O₃ | > 1 - 5 |
| CaO | > 0 - 1 |
| SrO | 0 - 1 |
| | |
| P₂O₅ | > 0 - 3 |
| | |
| B₂O₃ | > 0 - 4 |
| | |
| | |
| | |
| Fe₂O₃ | > 0 - 2 |
| CoO | 0 - 1 |
| NiO | 0 - 1 |
| | |
| | |
| | |
| ZnO | > 0 - 2 |
| ZrO₂ | > 0,5 -2 |

Vorzugsweise besitzt oder umfasst das Glas der ersten Ausführungsform die folgende Zusammensetzung:

| | |
|---|---|
| SiO₂ | 28 |
| TiO₂ | 23 |
| | |
| Na₂O | 16 |
| K₂O | 13 |
| Li₂O | 1,12 |
| Al₂O₃ | 3,4 |
| CaO | 0,2 |
| SrO | 0,02 |
| | |
| P₂O₅ | 1,6 |
| | |
| B₂O₃ | 2 |
| | |
| | |
| | |
| Fe₂O₃ | 0,2 |
| CoO | 0,03 |
| NiO | <0,02 |
| | |
| | |
| | |
| ZnO | 0,2 |
| ZrO₂ | 0,9 |

In einer zweiten bevorzugten Ausführungsform besitzt oder umfasst das Glas die folgende Zusammensetzung:

| | |
|---|---|
| SiO₂ | 36 - 40 |
| TiO₂ | 24 - 28 |
| | |
| Na₂O | 15 - 19 |
| K₂O | 10 - 14 |
| Li₂O | > 0 - 3 |
| Al₂O₃ | 1 - 6 |
| CaO | > 0 - 1 |
| SrO | < 1 |
| | |
| P₂O₅ | > 0 - 4 |
| | |
| B₂O₃ | > 0 - 2 |
| | |
| | |
| | |
| Fe₂O₃ | 0 - 2 |
| CoO | < 1 |
| NiO | < 1 |
| | |
| | |
| | |
| ZnO | < 1 |
| ZrO₂ | < 1 |

Vorzugsweise besitzt oder umfasst das Glas der zweiten Ausführungsform die folgende Zusammensetzung:

| | |
|---|---|
| SiO₂ | 38 |
| TiO₂ | 26 |
| | |
| Na₂O | 17 |
| K₂O | 11,6 |
| Li₂O | 1,22 |
| Al₂O₃ | 3,7 |
| CaO | 0,3 |
| | |
| | |
| P₂O₅ | 1,6 |
| | |
| B₂O₃ | 0,29 |
| | |
| | |
| | |
| Fe₂O₃ | 0,08 |
| CoO | |
| NiO | <0,02 |
| | |
| | |
| | |
| ZnO | 0 |
| ZrO₂ | 0,1 |

Die mit dem Glas gebildete Glasschicht oder im Detail die zwischen dem Basiskörper und dem Anschlusskörper gebildete Glasschicht besitzt im Allgemeinen eine Dicke von größer als etwa 30 µm. Dadurch kann ein gasdichter Verbund mit ausreichend hohen elektrisch isolierenden Eigenschaften bereitgestellt werden. Vorzugsweise beträgt die Dicke der Glasschicht etwa 30 µm bis etwa 500 µm, vorzugsweise etwa 100 µm bis etwa 300 µm.

Der elektrische Widerstand der Glasschicht, welche auf dem Alkali-Titan-Silikat-Glas, insbesondere mit den genannten Zusammensetzungen, basiert, liegt im Allgemeinen bei größer als 1 GΩ. Die Gasdichtheit ist im Allgemeinen kleiner als 1^{∗}10⁻⁸ mbar*l/s. Weiterhin zeichnet sich das Glas aus durch eine verbesserte Festigkeit und eine verbesserte chemische Beständigkeit. So kann insbesondere die Scherfestigkeit bei einem Probekörper (4 mm x 4 mm Verglasungsfläche und 100 µm nominelle Dicke der Glasschicht) mit dem erfindungsgemäßen Glas von durchschnittlich 60 N auf 105 N erhöht werden gegenüber dem Glas P8061. Ferner weist das erfindungsgemäße Glas gegenüber dem Glas G018-122 eine verbesserte chemische Beständigkeit auf. Die Galvanik kann nach dem Verglasen durchgeführt werden.

Im Allgemeinen kann das Glas durch zumindest ein Verfahren aufgebracht werden, welches ausgewählt ist aus einer Gruppe bestehend aus Dispensen, Bereitstellen eines vorzugsweise gestanzten Glasbandes und/oder Bereitstellen eines individuellen Vorformlings. Ein Glasband kann zum Beispiel durch in die Form eines Bandes gegossenen Schlickers bereitgestellt werden. Um eine effiziente Herstellung zu erzielen, kann das Glas in einer Matrix bereitgestellt werden.

Die Glasschicht ist zumindest abschnittsweise zwischen dem Mantel des Basiskörpers und dem Anschlusskörper angeordnet. Vorzugsweise ist die Glasschicht zumindest abschnittsweise zwischen dem Mantel des Basiskörpers und dem Mantel des Anschlusskörpers, vorzugsweise seines Durchgangsbereichs, angeordnet.

In einer alternativen oder ergänzenden Ausführungsform ist die Glasschicht zumindest abschnittsweise zwischen der Oberseite des Basiskörpers und einer Unterseite des Anschlusskörpers angeordnet.

Um ein verbessertes Anhaften des Anschlusskörpers an dem Basiskörper zu bewirken, erfolgt vorzugsweise eine Vorbehandlung der Glaskontaktflächen des Basiskörpers und/oder des Anschlusskörpers. Die genannte Vorbehandlung kann in einer Ausführungsform durch ein Voroxidieren der Glaskontaktflächen erfolgen. Unter dem Voroxidieren wird ein gezieltes Oxidieren einer Oberfläche, zum Beispiel in einer sauerstoffhaltigen Atmosphäre, verstanden. Dabei hat sich ein Verbund aus Glas und Kupfer oder Kupferoxid als sehr stabil erwiesen. Das Metall, vorzugsweise Kupfer, wird in einer sauerstoffhaltigen Atmosphäre gezielt oxidiert. Dabei hat sich für das Oxidgewicht ein Flächengewicht von etwa 0,02 bis etwa 0,25 mg/cm², vorzugsweise von etwa 0,067 bis etwa 0,13 mg/cm², Oxidgewicht als vorteilhaft erwiesen. Das Oxid haftet gut und blättert nicht ab. Dies ist insbesondere zutreffend, wenn das Kupfer mit einem Anteil von größer als 50 Gew.%, vorzugsweise von größer als 80 Gew.%, in dem Basiskörper und/oder in dem Anschlusskörper und/oder zumindest in den Grenzflächen bereitgestellt wird.

Zum Verbessern der Eigenschaften des Basiskörpers und/oder des Anschlusskörpers, beispielsweise der Reflektivität, der Bondbarkeit und/oder der elektrischen Leitfähigkeit, können diese, vorzugsweise zumindest abschnittsweise, beschichtet und/oder verkleidet sein, vorzugsweise mit einem Metall. Ein mögliches Verfahren stellt das Plattieren, vorzugsweise mittels Galavanotechnik, dar.

Das auf dem Basiskörper positionierbare opto-elektronische Funktionselement ist ein strahlungsemittierendes und/oder strahlungsempfangendes Bauteil. Vorzugsweise ist es als Chip ausgebildet. Das Funktionselement ist wenigstens ein Bauteil ausgewählt aus der Gruppe von LED, Photodiode und Laserdiode. Die Verwendung des erfindungsgemäßen Gehäuses ist insbesondere für LEDs mit einer hohen Leistung, vorzugsweise mit einer Leistung von größer als etwa 5 W, geeignet, da bei diesen eine effiziente Wärmeableitung erforderlich ist und das Gehäuse ausreichend thermisch stabil sein muss. Insbesondere auch für nicht optoelektronische Funktionselemente, wie zum Beispiel Leistungshalbleiter, deren Verwendung insbesondere eine ausreichende thermische Stabilität erfordert, kann das vorliegende erfindungsgemäße Gehäuse geeignet sein. Somit kann das erfindungsgemäße Gehäuse auch ein Gehäuse für ein opto-elektronisches Funktionselement und/oder allgemein für ein Funktionselement sein. Entsprechendes gilt für das erfindungsgemäße Verfahren.

In einer Weiterbildung ist in dem erfindungsgemäßen Gehäuse in der Oberseite des Anschlusskörpers und/oder in der Oberseite des Basiskörpers ein Aufnahmebereich zur Aufnahme und/oder zum Lagern eines Abschlusselements, wie zum Beispiel eines optischen Bauelements, ausgebildet.

Auf der Oberseite des Basiskörpers und/oder auf der Oberseite des Anschlusskörpers und dabei vorzugsweise in den Aufnahmebereich, ist gegebenenfalls wenigstens ein, vorzugsweise transparentes, Abschlusselement aufgebracht oder angeordnet. Das Abschlusselement ist insbesondere ein optisches Bauelement. Ein Beispiel für das optische Bauelement ist ein fokussierendes Bauteil, vorzugsweise eine Linse. Die Linse kann bereitgestellt werden durch eine vorzugsweise konvexe Glaslinse und/oder einen Tropfen, wie zum Beispiel einen Silikontropfen.

In einer weiteren Ausgestaltung des Gehäuses wird zumindest auf seiner Unterseite eine Isolation aufgebracht. Dazu wird auf der Unterseite des Basiskörpers und gegebenenfalls auf der Unterseite des Anschlusskörpers eine Isolation, welche vorzugsweise durch eine isolierende Schicht bereitgestellt wird, vorgesehen. Die Isolation kann durchgehend oder auch segmentiert sein. Das Material für die Isolation ist oder umfasst vorzugsweise ein Glas und/oder eine Keramik. Die Schicht kann zum Beispiel über ein Emaillieren und/oder ein Cold-Spray-Verfahren aufgebracht werden. Dadurch kann die Unterseite des Gehäuses potentialfrei bereitgestellt werden.

In einer weiteren Ausgestaltung des Gehäuses ist eine Hülse mantelseitig an dem Basiskörper angeordnet. Die Hülse oder Hülle erstreckt sich zumindest abschnittsweise über den Umfang des Basiskörpers und/oder des Anschlusskörpers. Die Hülse ist über die oder eine Glasschicht an dem Basiskörper und/oder an dem Anschlusskörper befestigt. Die Glasschicht befindet sich zwischen dem Basiskörper und der Hülse. Die Hülse wird vorzugsweise als eine metallische Hülse, zum Beispiel aus Edelstahl, bereitgestellt. Dadurch ist es möglich, zumindest die Außenseite des Gehäuses mit einem definierten Potential, beispielsweise mit dem Erdpotential, bereitzustellen.

Der Basiskörper, insbesondere mit der ersten und/oder einer zweiten Vertiefung und/oder mit weiteren Ausgestaltungen, und/oder der Anschlusskörper, insbesondere mit dem Durchgangsbereich und/oder der Lasche und/oder mit weiteren Ausgestaltungen werden durch ein Leiterrahmen-Verfahren hergestellt. Beispiele für ein solches Fertigungsverfahren stellen photochemisches Ätzen, Stanzen, Laser-Schneiden und/oder Wasserstrahlschneiden dar. Das Stanzen ist sehr kostengünstig und stellt daher das bevorzugte Verfahren zur Herstellung der genannten Bauteile dar. Somit werden auch in einer bevorzugten Ausführungsform der Erfindung im Wesentlichen nur stanzbare Metalle zur Herstellung des Basiskörpers und/oder des Anschlusskörpers verwendet. In einer Ausführungsform wird eine Platte derart strukturiert, dass eine Vielzahl von Bauteilen pro Platte entsteht. Das Gehäuse ist Bestandteil einer Matrix von einzelnen Gehäusen. Eine Matrix ist dann eine Art Grundkörper, in welchem die jeweiligen Bauteile eingelagert oder angeordnet sind. Daher liegt im Bereich der vorliegenden Erfindung auch ein Anordnung oder eine Matrix, welche eine Vielzahl von Gehäusen, vorzugsweise der vorstehend beschriebenen Gehäuse, umfasst. Die einzelnen Gehäuse sind über Stege oder Verbindungsstege an der jeweiligen Matrix befestigt. Daher kann die Erfindung auch beschrieben werden durch ein Verfahren zur Herstellung einer Vielzahl von opto-elektronischen Funktionselementgehäusen. Nach deren Herstellung werden die Gehäuse von der Matrix separiert.

Weiterhin erstreckt sich die Erfindung auf ein opto-elektronisches Bauteil, welches ein erfindungsgemäßes Gehäuse und wenigstens ein strahlungsemittierendes und/oder strahlungsempfangendes opto-elektronisches Funktionselement, insbesondere eine LED, das in dem Gehäuse angeordnet ist, umfasst.

Ferner liegt im Rahmen der vorliegenden Erfindung auch eine Beleuchtungseinrichtung, zum Beispiel eine Innenbeleuchtung und/oder eine Außenbeleuchtung, welche wenigstens ein Gehäuse und/oder ein opto-elektronisches Bauteil gemäß der vorliegenden Erfindung beinhaltet, insbesondere zum Einsatz in einem Fahrzeugen und/oder einem Flugzeug und/oder als Flugfeldbeleuchtung. Beispiele für die Beleuchtungseinrichtung sind eine Sitzbeleuchtung; ein Leselicht; eine Arbeitsleuchte, die insbesondere in Decken oder Wänden integrierbar ist; eine Objektbeleuchtung in Möbeln und/oder Gebäuden; ein Scheinwerfer und/oder ein Rücklicht und/oder eine Innenbeleuchtung und/oder eine Instrumenten- oder Display-Beleuchtung, vorzugsweise in Kraftfahrzeugen; eine Hintergrundbeleuchtung für LCD-Displays; eine UV-Beleuchtung, vorzugsweise in der Medizin und/oder zur Wasserreinigung; und/oder eine Beleuchtung für eine raue Umgebung ("harsh environment"), wie zum Beispiel unter Feuchtigkeitseinfluss und/oder aggressivem Gaseinflüssen und/oder Strahlungseinfluss.

Die vorliegende Erfindung wird anhand der nachfolgenden Ausführungsbeispiele im Einzelnen erläutert. Hierzu wird auf die beigefügten Zeichnungen Bezug genommen. Die gleichen Bezugszeichen in den einzelnen Zeichnungen beziehen sich auf die gleichen Teile.

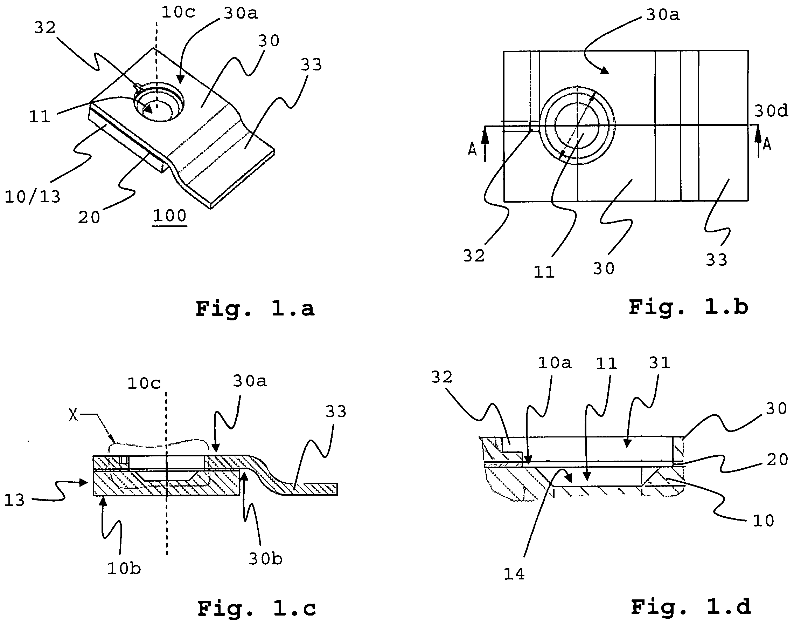

Fig. 1.a bis 1.d illustrieren eine erste Ausführungsform eines 2-lagigen nicht der Erfindung entsprechenden Gehäuses mit einer ersten Vertiefung im Basiskörper in einer perspektivischen Ansicht auf die Oberseite (Fig. 1.a), einer Aufsicht auf die Oberseite (Fig. 1.b), in einem Querschnitt entlang der Längsachse A-A (Fig. 1.c) und in einem vergrößerten Querschnitt des mit X gekennzeichneten Bereichs (Fig. 1.d).

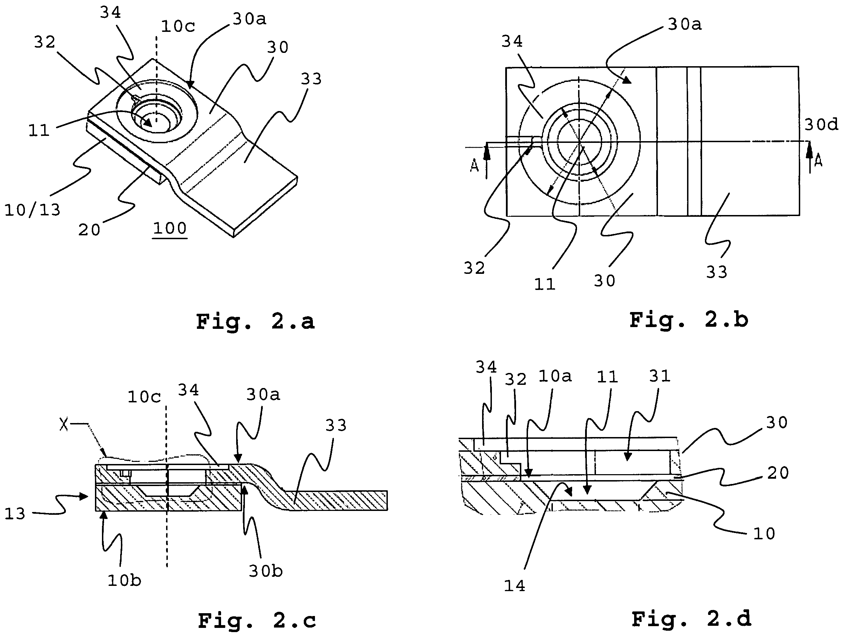

Fig. 2.a bis 2.d illustrieren eine zweite Ausführungsform eines 2-lagigen nicht der Erfindung entsprechenden Gehäuses mit einer ersten Vertiefung im Basiskörper in einer perspektivischen Ansicht auf die Oberseite (Fig. 2.a), einer Aufsicht auf die Oberseite (Fig. 2.b), in einem Querschnitt entlang der Längsachse A-A (Fig. 2.c) und in einem vergrößerten Querschnitt des mit X gekennzeichneten Bereichs (Fig. 2.d).

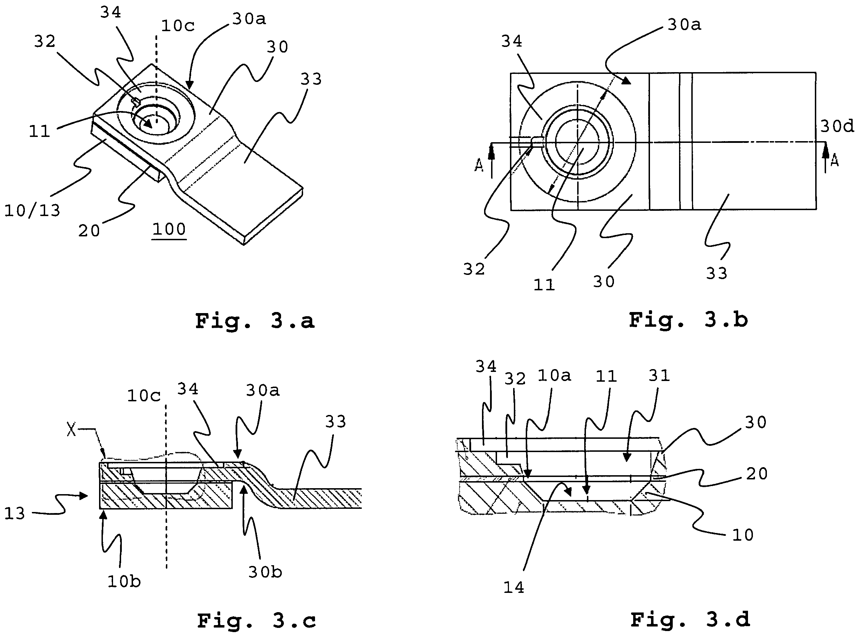

Fig. 3.a bis 3.d illustrieren eine dritte Ausführungsform eines 2-lagigen nicht der Erfindung entsprechenden Gehäuses mit einer ersten Vertiefung im Basiskörper in einer perspektivischen Ansicht auf die Oberseite (Fig. 3.a), einer Aufsicht auf die Oberseite (Fig. 3.b), in einem Querschnitt entlang der Längsachse A-A (Fig. 3.c) und in einem vergrößerten Querschnitt des mit X gekennzeichneten Bereichs (Fig. 3.d).

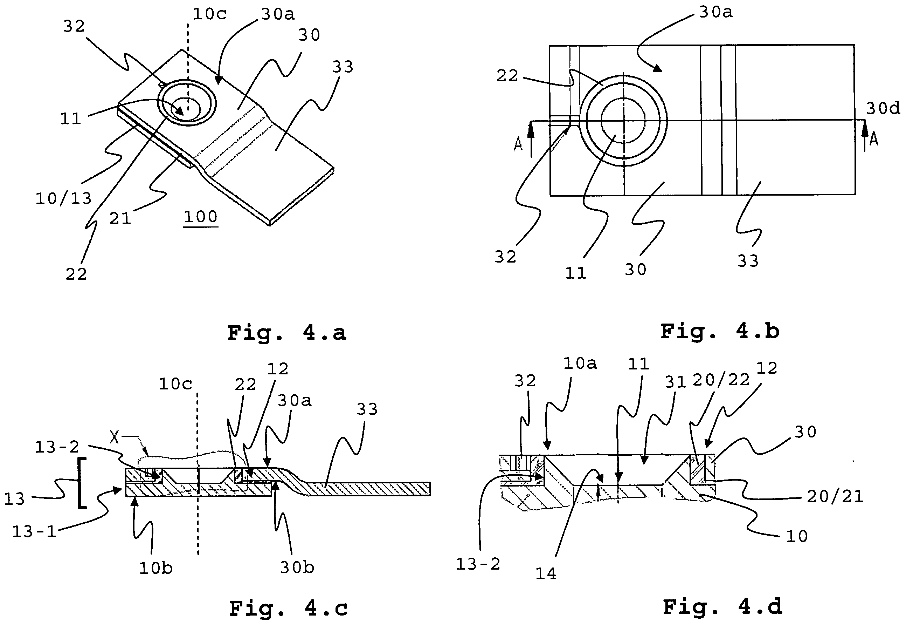

Fig. 4.a bis 4.d illustrieren eine erste Ausführungsform eines der Erfindung entsprechenden 2-lagigen Gehäuses mit einer ersten und einer zweiten Vertiefung im Basiskörper und einem mantelseitig am Basiskörper montierten Anschlusskörper in einer perspektivischen Ansicht auf die Oberseite (Fig. 4.a), einer Aufsicht auf die Oberseite (Fig. 4.b), in einem Querschnitt entlang der Längsachse A-A (Fig. 4.c) und in einem vergrößerten Querschnitt des mit X gekennzeichneten Bereichs (Fig. 4.d).

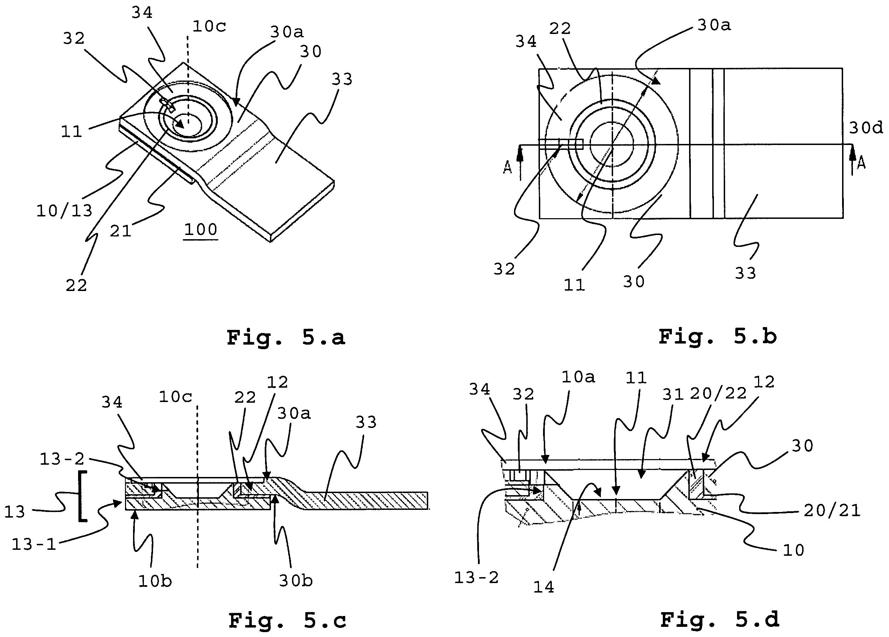

Fig. 5.a bis 5.d illustrieren eine zweite Ausführungsform eines 2-lagigen der Erfindung entsprechenden Gehäuses mit einer ersten und einer zweiten Vertiefung im Basiskörper und einem mantelseitig am Basiskörper montierten Anschlusskörper in einer perspektivischen Ansicht auf die Oberseite (Fig. 5.a), einer Aufsicht auf die Oberseite (Fig. 5.b), in einem Querschnitt (Fig. 5.c) entlang der Längsachse A-A und in einem vergrößerten Querschnitt des mit X gekennzeichneten Bereichs (Fig. 5.d).

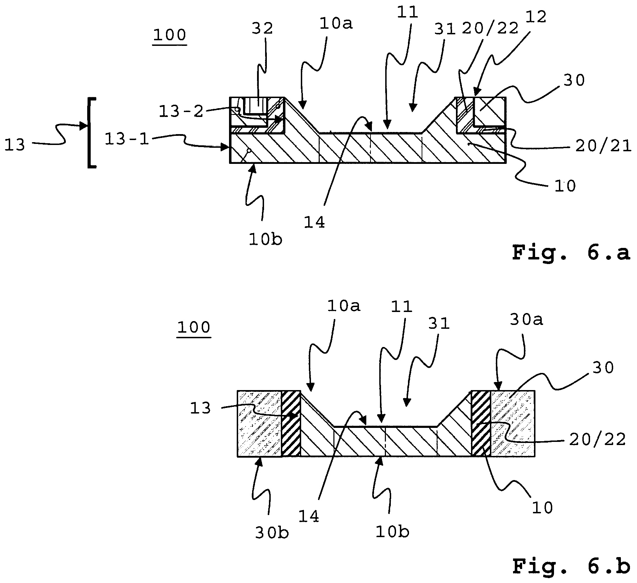

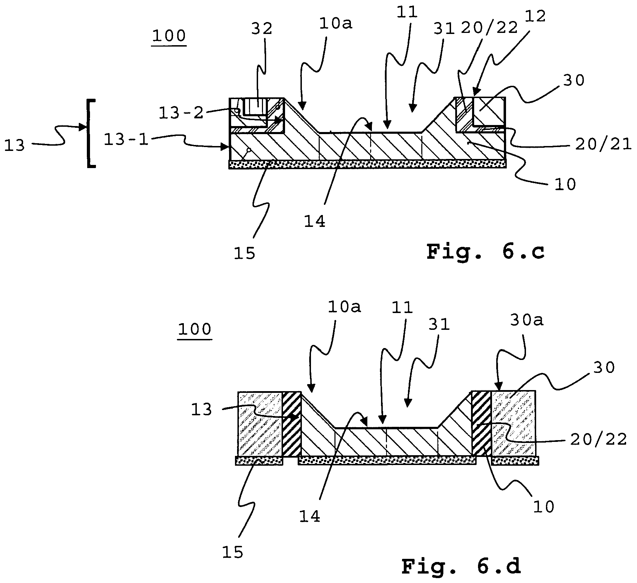

Fig. 6.a bis 6.d illustrieren Ausführungsformen eines 2-lagigen Gehäuses mit einem mantelseitig am Basiskörper montierten Anschlusskörper in einem Querschnitt ohne (Fig. 6.a und 6.b) und mit Isolationsschicht (Fig. 6.c und 6.d), wobei Fig. 6.a und 6.c ein entsprechend der Erfindung und Fig. 6.b und 6.d ein nicht der Erfindung entsprechendes Gehäuse zeigen.

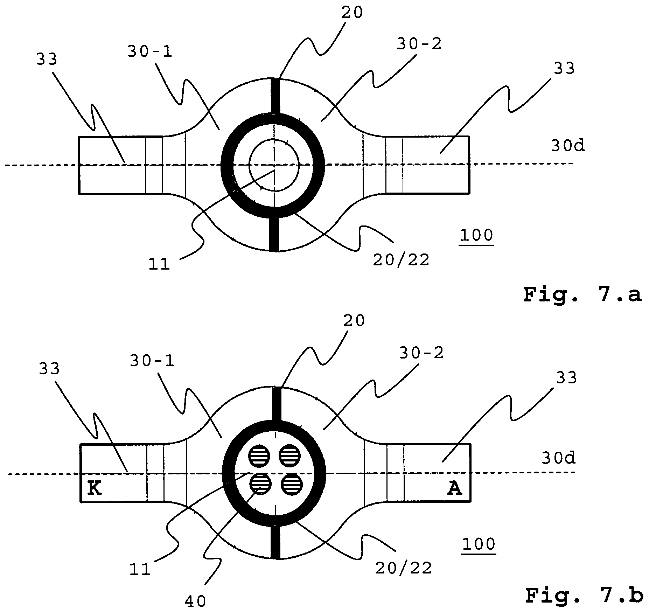

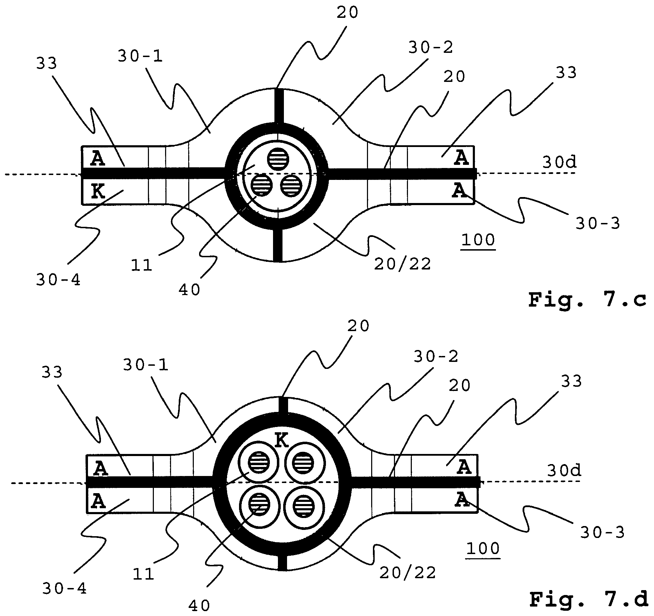

Fig. 7.a bis 7.d illustrieren einige Ausführungsformen eines der Erfindung entsprechenden 2-lagigen Gehäuses mit einem segmentierten am Basiskörper montierten Anschlusskörper in einer Aufsicht auf die Oberseite.

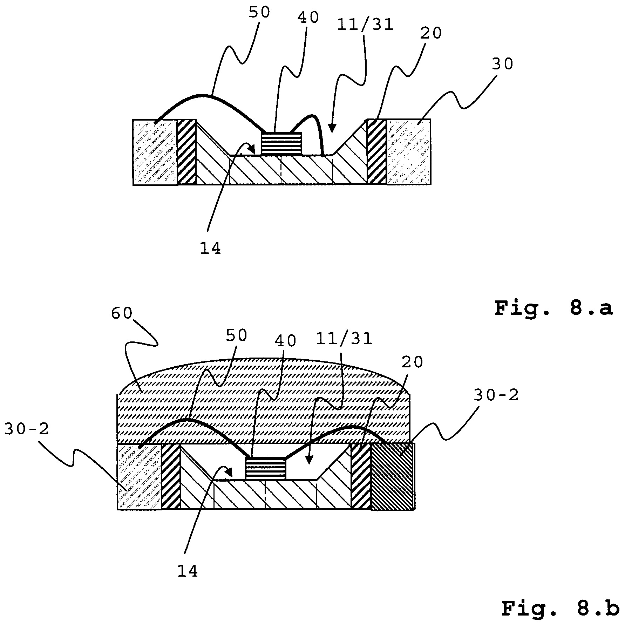

Fig. 8.a und 8.b illustrieren nicht der Erfindung entsprechende mögliche Kontaktierungen für ein einzelnes in der ersten Aussparung positioniertes opto-elektronisches Funktionselement.

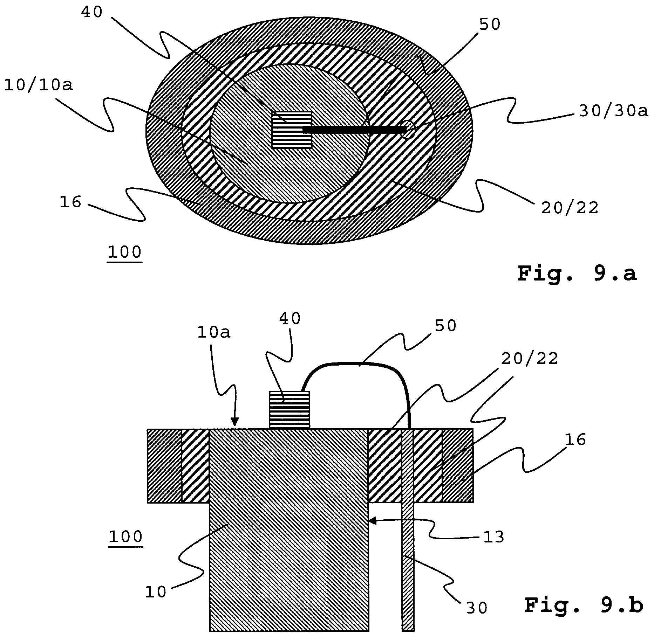

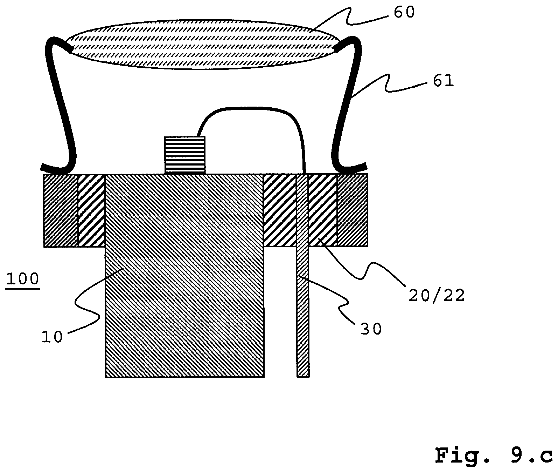

Fig. 9.a bis 9.c illustrieren eine weitere Ausführungsform eines nicht der Erfindung entsprechenden 2-lagigen Gehäuses mit einem mantelseitig an dem Basiskörper montierten Anschlusskörper in einer Aufsicht auf die Oberseite (Fig. 9.a), in einem Querschnitt (Fig. 9.b) und in einem Querschnitt mit einem aufgesetzten Abschlusselement (Fig. 9.c).

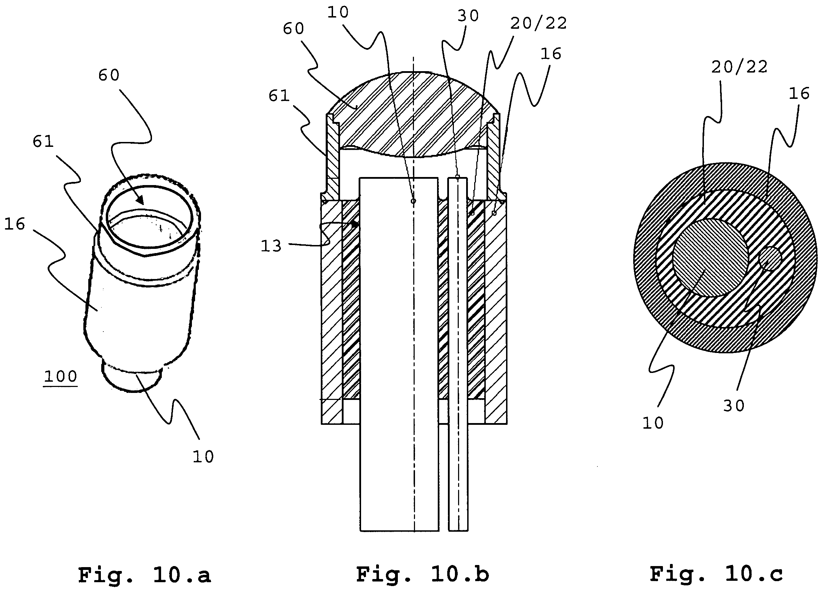

Fig. 10.a bis 10.c zeigen eine modifizierte Ausführungsform eines nicht der Erfindung entsprechenden 1-lagigen Gehäuses in einer perspektivischen Ansicht (Fig. 10.a), in einem Querschnitt (Fig. 10.b) und in einer Aufsicht auf die Oberseite (Fig. 10.c).

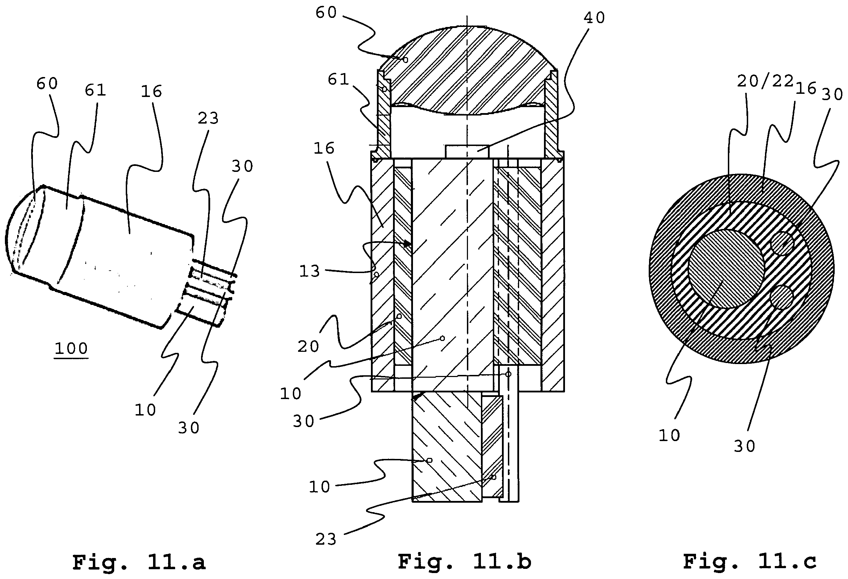

Fig. 11.a bis 11.c zeigen eine modifizierte Ausführungsform eines nicht der Erfindung entsprechenden 1-lagigen Gehäuses in einer perspektivischen Ansicht (Fig. 11.a), in einem Querschnitt (Fig. 11.b) und in einer Aufsicht auf die Oberseite (Fig. 11.c).

### Detaillierte Beschreibung der Erfindung

Die Figuren 1.a bis 1.d zeigen eine erste Ausführungsform eines nicht der Erfindung entsprechenden 2-lagigen oder zumindest 2-lagigen Gehäuses 100 mit einer einzelnen, hier ersten Vertiefung 11 im Basiskörper 10. Auf dem Basiskörper 10 ist ein Anschlusskörper 30 angeordnet. Der Basiskörper 10 und der Anschlusskörper 30 sind über eine Glasschicht 20 stoffschlüssig miteinander verbunden.

Der Basiskörper 10 hat eine Oberseite 10a, eine Unterseite 10b und einen Mantel 13 oder Rand 13 und eine Zentralachse 10c. In dem gezeigten Beispiel hat der Basiskörper 10 einen quadratischen Querschnitt. Seine Oberseite 10a weist eine erste Vertiefung 11 auf, zum Beispiel bereitgestellt durch eine Aussparung 11. Sie ist vorzugsweise zentrisch im und/oder koaxial zum Basiskörper 10 angeordnet. Die erste Vertiefung 11 besitzt hier einen runden, vorzugsweise kreisförmigen, Querschnitt. Er kann aber auch rechteckig, vorzugsweise quadratisch, sein. Der Durchmesser der ersten Vertiefung 11 vergrößert sich, vorzugsweise kontinuierlich, ausgehend von dem Boden der ersten Vertiefung 11 zu seiner Oberseite. Die erste Vertiefung 11 besitzt die Gestalt eines Kegelstumpfs. Diese kann aber auch die Gestalt eines Pyramidenstumpfs haben. In der ersten Vertiefung 11 oder auf dem Boden der ersten Vertiefung 11 wird ein hier nicht dargestelltes opto-elektronisches Funktionselement 40 positioniert. Das Funktionselement 40 ist insbesondere im Zentrum der ersten Vertiefung 11 und/oder koaxial zum Basiskörper 10 und/oder zur ersten Vertiefung 11 angeordnet (siehe dazu die Figuren 8.a und 8.b).

Der Basiskörper 10 ist als eine metallische Platte, vorzugsweise eine Kupferplatte, ausgeführt. An der Oberseite 10a des Basiskörpers 11 ist der Montagebereich 14 für wenigstens ein opto-elektronisches Funktionselement 40 definiert. Der Montagebereich 14 wird hier bereitgestellt durch den Boden der ersten Vertiefung 11 in der Oberseite 10a des Basiskörpers 10. Insbesondere im Hinblick auf die Fertigungskosten wird der Basiskörper 10, insbesondere zusammen mit der ersten Vertiefung 11 und/oder einer zweiten Vertiefung 12 und/oder mittels Stanzen hergestellt.

Auf dem Basiskörper 10 oder auf der Oberseite 10a des Basiskörpers 10 ist der Anschlusskörper 30 angeordnet. Der Anschlusskörper 30 hat eine Oberseite 30a, eine Unterseite 30b und eine Längsachse 30d. Der Anschlusskörper 30 ist eine metallische Platte, vorzugsweise eine Kupferplatte. Im Anschlusskörper 30 wird ein Durchgangsbereich 31 für die von dem opto-elektronischen Funktionselement 40 emittierte und/oder zu empfangende Strahlung bereitgestellt. Der Durchgangsbereich 31 wird vorzugsweise als eine Aussparung 31 oder Loch 31 in dem Anschlusskörper 30 bereitgestellt. Der Durchgangsbereich 30 ist vorzugsweise koaxial zur ersten Vertiefung 11 im Basiskörper 11 angeordnet.

An einer Innenseite des Durchgangsbereichs 31 ist ein Bereich 32 zum Anschließen eines nicht dargestellten Bonddrahts 50, über den das opto-elektronische Funktionselement 40 kontaktierbar ist, vorgesehen. Vorzugsweise ist dieser Anschlussbereich 32 als eine Aussparung 32 im Anschlusskörper 30 ausgeführt.

Der Durchgangsbereich 31 besitzt die Gestalt eines geraden Zylinders mit vorzugsweise kreisförmigem Querschnitt. Der Durchmesser des Durchgangsbereichs 31 ist hier größer als der, vorzugsweise obere, Durchmesser der ersten Vertiefung 11 im Basiskörper 10.

Der Anschlusskörper 30 besitzt im Wesentlichen die gleichen Abmessungen wie der Basiskörper 10. Zusätzlich weist jedoch der Anschlusskörper 30 noch eine seitliche Erstreckung 33 oder Lasche 33 auf. Sie erstreckt sich über den seitlichen Rand 13 des Basiskörpers 10 hinaus. Sie ist vorzugsweise biegbar oder bereits, wie hier dargestellt gebogen, so dass zum Beispiel ein Kontakt zu einer Leiterbahn einer Platine, auf die das Gehäuse 100 im Betriebszustand aufgesetzt wird, herstellbar ist.

Insbesondere um die Fertigungskosten möglicht gering halten zu können, wird der Anschlusskörper 30, insbesondere zusammen mit dem eingebrachten Durchgangsbereich 31 und/oder dem Anschlussbereich 32 und/oder der Lasche 33 und/oder mittels Stanzen hergestellt.

Zwischen der Oberseite 10a des Basiskörpers 10 und der Unterseite 30b des Anschlusskörpers 30 ist die Glasschicht 20 angeordnet. Diese verbindet den Basiskörper 10 mit dem Anschlusskörper 30. Das Glas der Glasschicht 20 ist ein Glas zum Verbinden von Basiskörper 10 und Anschlusskörper 30. In einer bevorzugten Ausführung der Erfindung ist das Glas ein Alkali-Titan-Silikat-Glas.

In einem ersten Verfahrensschritt werden der Basiskörper 10 mit der ersten Vertiefung 11 und der Anschlusskörper 30 mit dem Durchgangsbereich 31, dem Anschlussbereich 32 und der Lasche 33 bereitgestellt. In einer ersten Variante des Verfahrens wird ein Vorformling 20 zwischen dem Basiskörper 10 und dem Anschlusskörper 30 bereitgestellt. Ein Vorformling 20 ist günstig in der Herstellung und einfach zu handhaben. Der Vorformling 20 weist im Zentrum eine Öffnung entsprechend der Aussparung 31 im Anschlusskörper 30 auf. Basiskörper 10, Anschlusskörper 30 und Glasband 20 werden zueinander ausgerichtet. Wenigstens der Vorformling 20 wird indirekt oder direkt erwärmt. Der Basiskörper 10 und der Anschlusskörper 30 mit dem dazwischen liegenden Vorformling 20 werden zusammengepresst. Das gebildete Gehäuse 100 oder der gebildete Verbund wird dann abgekühlt. In einer zweiten Variante wird das Glas 20 mittels Dispensen bereitgestellt. Über das Dispensen kann jede Größe oder Form des Glases einfach bereitgestellt werden.

Ein in der ersten Vertiefung 11 positioniertes optoelektronische Funktionselement 40 ist geschützt in dem Gehäuse 100 gelagert. Ist das Funktionselement 40 zum Beispiel als eine LED ausgeführt, so kann die Innenseite oder der Mantel der ersten Vertiefung 11 im Basiskörper 10 und/oder des Durchgangsbereichs 31 im Anschlusskörper 30 zur Verbesserung der Beleuchtung, insbesondere zumindest abschnittsweise, reflektierende Eigenschaften besitzen. Die erste Vertiefung 11 und/oder der Durchgangsbereich 31 kann bzw. können somit auch als Reflektor bezeichnet werden. In Abhängigkeit von dem Material und/oder von der Art der Herstellung kann die Innenseite der ersten Vertiefung 11 und/oder des Durchgangsbereichs 31 bereits ausreichende reflektierende Eigenschaften besitzen. Im Allgemeinen wird jedoch eine Nachbearbeitung der Innenseite erforderlich sein. Die reflektierenden Eigenschaften können zum einen durch ein entsprechendes Bearbeiten der Innenseite, beispielsweise durch Polieren, erreicht werden. Als Alternative oder als Ergänzung kann die Innenseite auch noch abschnittsweise oder vollständig beschichtet und/oder verkleidet sein, vorzugsweise mit einem Metall. Das Metall zur Herstellung der Beschichtung und/oder der Verkleidung ist wenigstens ein Material, das ausgewählt ist aus einer Gruppe bestehend aus Silber, Aluminium, Nickel, Palladium und Gold. Das Verfahren zum Erzeugen oder Herstellen der Beschichtung ist wenigstens ein Verfahren, das ausgewählt ist aus einer Gruppe bestehend aus Galvanisieren und Verdampfen, insbesondere PVD und/oder CVD.

Nach dem Einbau des opto-elektronischen Funktionselements 40 kann auf dem Anschlusskörper 30 beispielsweise ein optisches Bauteil 60, wie eine Linse 60, angeordnet werden. Es wird eine Art Abdeckung bereitgestellt. Vorzugsweise wird das optische Bauteil 60 derart befestigt, dass der Innenraum des Gehäuses 100 hermetisch abgeschlossen ist.

Um Wiederholungen zu vermeiden, werden für die nachfolgend beschriebenen Ausführungsformen jeweils nur die Änderungen beschrieben gegenüber den in den jeweils vorangegangenen Figuren dargestellten Ausführungsformen. Für identische oder auch ähnliche Merkmale sei jeweils auf die vorab beschriebenen Ausführungsformen verwiesen.

Die Figuren 2.a bis 2.d zeigen eine zweite nicht der Erfindung entsprechende Ausführungsform. Als Änderung gegenüber der in den Figuren 1.a bis 1.d gezeigten ersten erfindungsgemäßen Ausführungsform ist zusätzlich in der Oberseite 30a des Anschlusskörpers 30 noch ein Aufnahmebereich 34 für ein optisches Bauelement 60 vorgesehen. Dadurch kann das optische Bauelement 60 präzise und sicher auf dem Gehäuse 100, insbesondere auf dem Anschlusskörper 30, positioniert und beispielsweise mittels Kleben verbunden werden. Das optische Bauelement 60 ist zum Beispiel eine Linse 60, insbesondere eine Glaslinse. Der Aufnahmebereich 34 ist an den Durchgangsbereich 31 angepasst. Er hat im Wesentlichen die gleiche Form oder Gestalt wie der Durchgangsbereich 31. Der Aufnahmebereich 34 besitzt in der gezeigten Version einen im Wesentlichen runden, vorzugsweise kreisförmigen, Querschnitt. Er wird durch eine Vertiefung 34 oder eine Aussparung 34 in der Oberseite 30a des Anschlusskörpers 30 bereitgestellt. Die Vertiefung 34 besitzt einen gegenüber dem Durchgangsbereich 31 des Anschlusskörpers 30 größeren Querschnitt. Sie besitzt eine beispielhafte Tiefe von etwa 0,1 bis 1 mm. Die Auflagefläche liegt vorzugsweise in einem Bereich von 0,5 mm bis 20 mm.

Die Figuren 3.a bis 3.d zeigen eine dritte nicht der Erfindung entsprechende Ausführungsform. Als Änderung zu der in den Figuren 2.a bis 2.c gezeigten Ausführungsform besitzt der Durchgangsbereich 31 im Anschlusskörper 30 hier einen Querschnitt, der sich, ausgehend von der Unterseite 30b des Anschlusskörpers 30 in Richtung seiner Oberseite 30a, vorzugsweise kontinuierlich, vergrößert. Der Durchgangsbereich 31 hat im Wesentlichen die Gestalt eines Kegelstumpfs. Hat die Innenseite oder der Mantel des Durchgangsbereichs 31 zumindest abschnittsweise reflektierende Eigenschaften, so kann der Durchgangsbereich 31 in dem Anschlusskörper 30 somit auch als Reflektor 31 bezeichnet werden. Dieser schließt sich dem Reflektor 11 im Basiskörper 10 an. Der Reflektor 11 in dem Basiskörper 10 und der Reflektor 31 in dem Anschlusskörper 30 bilden zusammen den Reflektor des Gehäuses 100. Die Formen der beiden Reflektoren 11 und 31 entsprechen im Wesentlichen einander. Die beiden Reflektoren 11 und 31 gehen dabei ineinander über. Der obere Abschnitt des Reflektors 11 im Basiskörper 10 entspricht in seinen Abmessungen und seiner Form im Wesentlichen den Abmessungen und der Form des unteren Abschnitts des Reflektors 31 im Anschlusskörper 30. Für weitere konkrete Ausgestaltungen des Reflektors 31 im Anschlusskörper 30 sei auf die Ausführungen zum Reflektor 11 im Basiskörper 10 verwiesen.

In den vorstehend beschriebenen Ausführungsformen sind der Basiskörper 10 und der Anschlusskörper 30 über eine Glasschicht 20 verbunden, welche sich im Wesentlichen nur zwischen der Oberseite 10a des Basiskörpers 10 und der Unterseite 30b des Anschlusskörpers 30 befindet. Die nachfolgend beschriebenen Ausführungsformen zeigen dagegen ein Gehäuse 100, in welchem der Basiskörper 10 und der Anschlusskörper 30, insbesondere zusätzlich, über eine Glasschicht 20 verbunden sind, welche zwischen dem Mantel 13 des Basiskörpers 10 und dem Anschlusskörper 30 oder der Innenseite des Durchgangsbereichs 31 des Anschlusskörpers 30 angeordnet ist.

Die Figuren 4.a bis 4.d zeigen eine erste Ausführungsform eines der Erfindung entsprechenden 2-lagigen Gehäuses 100 mit einer ersten Vertiefung 11 im Basiskörper 10 zum Positionieren und/oder zum Aufnehmen des Funktionselements 40 und zusätzlich mit einer zweiten Vertiefung 12 im Basiskörper 10 zum Befestigen und/oder zum Aufnehmen des Anschlusskörpers 30. Der Anschlusskörper 30 ist am Mantel 13 des Basiskörpers 10 bzw. mantel- oder randseitig am Basiskörper 10 montiert.

Die erste Vertiefung 11 ist wiederum in dem Zentrum 10c des Basiskörpers 10 angeordnet. Indessen erstreckt sich die zweite Vertiefung 12 vollständig über den Umfang der ersten Vertiefung 11. Die zweite Vertiefung 12 ist zum Beispiel in den Figuren 4.c und 4.d zu erkennen. Diese ist jedoch nicht isoliert dargestellt, wie zum Beispiel die erste Aussparung 11. Vielmehr ist die zweite Vertiefung in den zwei Figuren bereits mit der Glasschicht 20 und dem Anschlusskörper 30 aufgefüllt.

Durch die umlaufende zweite Vertiefung 12 wird der Mantel 13 des Basiskörpers 10 durch einen segmentierten Mantel 13 gebildet. Er wird durch einen unteren äußeren Mantel 13-1 oder Mantelabschnitt 13-1 und einen oberen inneren Mantel 13-2 oder Mantelabschnitt 13-2 gebildet. Auch die zweite Vertiefung 12 ist vorzugsweise als eine Aussparung 12 in dem Basiskörper 10 ausgeführt. In einer Aufsicht auf den Basiskörper 10 stellt die zweite Vertiefung 11 eine Art Kreisring dar. Der Kreisring wird von dem äußeren Mantel 13-1 des Basiskörpers 10 und von dem inneren Mantel 13-2 des Basiskörpers 10 oder der äußeren Kante der Wand, die den Reflektor 11 im Basiskörper 10 bildet, begrenzt. Der Mantel 13 oder Rand 13 des Basiskörpers 10 wird hier durch den unteren Abschnitt 13-1 und den oberen Abschnitt 13-2 gebildet. Der obere Abschnitt 13-2 ist im Vergleich zum unteren Abschnitt 13-1 zum Zentrum hin nach innen versetzt.

In einem Querschnitt kann der Basiskörper 10 als eine Art Untertasse beschrieben werden. Die innen liegende erste Vertiefung 11 stellt den Reflektor 11 bereit. Die außen liegende zweite Vertiefung 12 stellt eine Art Plateau zum Auflegen des Anschlusskörpers 30 bereit. Die erste Vertiefung 11 und die zweite Vertiefung 12 sind durch eine Art Wand getrennt, die mit ihrer Innenseite den Reflektor 11 für die von dem opto-elektronischen Funktionselement 40 zu emittierende oder zu empfangende Strahlung bildet. Die zweite Vertiefung 12 kann im Wesentlichen die Auflagefläche für den Anschlusskörper 30 auf dem Basiskörper beschreiben.

Der Anschlusskörper 30 liegt hier mit der Innenseite seines Durchgangsbereichs 31 an dem inneren oberen Mantel 13-2 des Basiskörpers 10 an. Zusätzlich liegt der Anschlusskörper 30 abschnittsweise mit der Unterseite 30b auf der Oberseite 10a des Basiskörpers 10 oder auf dem Boden der zweiten Vertiefung 12 auf.

Der Anschlusskörper 30 und der Basiskörpers 10 sind durch die Glasschicht 20 sowohl voneinander elektrisch isoliert als auch miteinander verbunden. Die Glasschicht 20 liegt, insbesondere im verbundenen Zustand, zum einen zwischen dem oberen inneren Mantel 13-2 des Basiskörpers 10 und der Innenseite des Durchgangsbereichs 31 im Anschlusskörper 30 und zum anderen zwischen der Oberseite 10a des Basiskörpers 10 und der Unterseite 30b des Anschlusskörpers 30. In dem Querschnitt ist zu erkennen, dass eine Art L-förmiger Glasverbund gebildet wird (siehe insbesondere die Figuren 4.c und 4.d). Ein erster Schenkel 21 der Glasschicht 20 verläuft im Wesentlichen entlang, vorzugsweise parallel zu, dem Boden der zweiten Vertiefung 12. Ein zweiter Schenkel 22 der Glasschicht 20 verläuft im Wesentlichen quer, vorzugsweise senkrecht, zu dem ersten Schenkel 21 der Glasschicht 20. Der zweite Schenkel 22 verläuft entlang, vorzugsweise parallel zu, dem inneren Mantel 13-2 des Basiskörpers 10. Die Breite der zweiten Vertiefung 12 wird im Wesentlichen beschrieben durch den ersten Schenkel 21 der Glasschicht 20.

Die Höhe des Anschlusskörpers 30 und/oder die Tiefe der zweiten Vertiefung 12 und/oder die Höhe der Glasschicht 20 oder 21 ist bzw. sind so bemessen, dass die Oberseite 30a des Anschlusskörpers 30 im Wesentlichen mit der obersten Kante der Oberseite 10a des Basiskörpers 10 abschließt.

Ein Vorteil dieser erfindungsgemäßen Ausführungsform liegt darin begründet, dass das Gehäuse 100 mit einer geringen Höhe bereitstellbar ist. Ein weiterer Vorteil ergibt sich aus der Begebenheit, dass keine Glasnaht oder kein Glas in dem Reflektor 11 und/oder in dem Durchgangsbereich 31 für das Licht vorhanden ist. Dadurch können gegebenenfalls reflektierende Eigenschaften des Reflektors 11 zum Beispiel durch ein dunkles Glas nicht nachteilig beeinflusst werden. Es sei angemerkt, dass die Öffnung 31 im Anschlusskörper 30, auch wenn sie sich nicht mehr direkt im Strahlengang befindet und somit keinen Reflektor bereitstellen kann, immer noch als Durchgangsbereich 31 beschrieben wird. Denn das Funktionselement 40 bzw. die von ihm emittierte oder empfangene Strahlung liegt immer noch im Bereich der Öffnung 31 des Anschlusskörpers 30. Der Reflektor 11 in dem Basiskörper 10 und der Durchgangsbereich 31 in dem Anschlusskörper 30 bzw. deren Volumina überschneiden sich oder liegen, vorzugsweise zumindest abschnittsweise, übereinander.

Die Figuren 5.a bis 5.d zeigen eine zweite Ausführungsform dieser Variante. Als Änderung gegenüber dem in den Figuren 4.a bis 4.d gezeigten Gehäuse 100 ist in der Oberseite 30a des Anschlusskörpers 30 zusätzlich noch ein Aufnahmebereich 34 für ein optisches Funktionselement 40 vorgesehen. Für weitere Details zu dem Aufnahmebereich 34 sei auf die Beschreibung zu den Figuren 2.a bis 2.d verwiesen.

Nachfolgend sind in den Figuren 6.a und 6.b zwei weitere Ausführungsformen des 2-lagigen Gehäuses 100 mit einer ersten und einer zweiten Vertiefung 11 und 12 in dem Basiskörper 10 sowie einem mantelseitig am Basiskörper 10 montierten Anschlusskörper 30 dargestellt.

Zunächst zeigt Figur 6.a ein Gehäuse 100, in welchem der Basiskörper 10 und der Anschlusskörper 30 in der gleichen Weise verbunden sind, wie in dem in den Figuren 4.a bis 4.d dargestellten Gehäuse 100. Im Unterschied dazu besitzt der Anschlusskörper 30 hier keine Lasche. Der Anschlusskörper 30 besitzt einen im Wesentlichen gleichen Querschnitt und eine im Wesentlichen gleiche Form wie der Basiskörper 10.

Weiterhin ist in Figur 6.b ein nicht entsprechend der Erfindung ausgestaltetes Gehäuse 100 gezeigt, in dem der Anschlusskörper 30 ausschließlich über die Mantelseite 13 an dem Basiskörper 10 befestigt ist. Die zwei Lagen sind hier nicht übereinander sondern nebeneinander angeordnet. Der Anschlusskörper 30 ist ein Körper oder Bauteil mit einer Öffnung 31 oder einem Durchgangsbereich 31, die bzw. der einen Querschnitt besitzt, welcher derart an die Gestalt und/oder die Abmessungen des Basiskörpers 10 angepasst ist, dass der Anschlusskörper 30 den Basiskörper 10 in seinem Inneren bzw. Durchgangsbereich 31 aufnehmen kann. Der Innendurch-messer des Anschlusskörpers 30 oder des Durchgangbereichs 31 im Anschlusskörper 30 ist größer als der Außendurch-messer des Basiskörpers 10 und derart groß gewählt, dass eine Glasschicht 20 oder 22 dazwischen angeordnet werden kann. Der Anschlusskörper 30 ist hier eine Art hohler Zylinder oder Ring oder ein Körper mit einer zylindrischen Öffnung 31, der über den hier runden, vorzugsweise kreis-förmigen, Basiskörper 10 gezogen wird.

Der Anschlusskörper 30 ist mantel- oder randseitig an dem Basiskörper 10 befestigt. Die verbindende Glasschicht 20 oder 22 ist in dieser Ausgestaltung des Gehäuses 100 nur zwischen der Außenseite des Basiskörpermantels 13 und der Innenseite des Anschlusskörpermantels angeordnet. In dem Querschnitt ist zu erkennen, dass eine Art I-förmiger Glasverbund gebildet wird. Es wird eine Art Ring-in-RingSystem um den Basiskörper 10 herum gebildet. Dabei stellt die verbindende Glasschicht 20 oder 22 stellt einen ersten Ring und der Anschlusskörper 30 einen zweiten Ring dar. Diese sind zusammen um den Basiskörper 10 herum angeordnet. Der Anschlusskörper 30 und die Glasschicht 20 oder 22 erstreckt bzw. erstrecken sich hier vollständig und/oder kontinuierlich über den Umfang des Basiskörpers 10 und den Reflektor 11.

Die Figuren 6.c und 6.d zeigen die gleichen Ausgestaltungen wie in den Figuren 6.a und 6.b. Zusätzlich ist jeweils auf der Unterseite 10b des Basiskörpers 10 und gegebenenfalls auf der Unterseite 30b des Anschlusskörpers 30 noch eine Isolation 15, insbesondere eine isolierende Schicht 15, aufgebracht. Die Unterseite 10b des Basiskörper 10 ist in Figur 6.c vollständig oder im Wesentlichen vollständig mit der Isolation 15 bedeckt. In der Figur 6.d ist dagegen die Isolation 15 segmentiert ausgeführt. Die metallischen Bauteile, hier die Unterseite 10b des Basiskörpers 10 und die Unterseite 30b des Anschlusskörpers 30, sind mit der Isolation 15 bedeckt. Dadurch ist die Unterseite des Gehäuses 100 potentialfrei bereitstellbar.

Allen bisher dargestellten Ausführungsformen ist gemeinsam, dass sich der Anschlusskörper 30 vollständig oder im Wesentlichen vollständig oder kontinuierlich über den Umfang des Reflektors 11 im Basiskörper 10 und/oder des gebildeten Durchgangsbereichs 31 im Anschlusskörper 30 erstreckt. Der Anschlusskörper 30 ist jeweils einstückig oder kontinuierlich ausgebildet. Er stellt einen einzelnen vorzugsweise elektrischen Anschluss, zum Beispiel für eine Anode oder eine Kathode einer LED 40, bereit.

Im Unterschied dazu ist nun der Anschlusskörper 30 in den Figuren 7.a bis 7.d segmentiert ausgeführt oder in Segmente 30-1 bis 30-4 unterteilt, welche vorzugsweise voneinander elektrisch isoliert sind. Ein segmentierter Anschlusskörper 30 stellt eine Vielzahl von Anschlüssen bereit oder stellt eine Vielzahl von Anschlusskörpern 30-1 bis 30-4 dar. Diese sind zueinander elektrisch isoliert. Die Segmente 30-1 bis 30-4 können entsprechend der in Figur 6.a oder der in Figur 6.b gezeigten Ausführungsform am Basiskörper montiert sein.

In Figur 7.a ist der Anschlusskörper 30 2-teilig. Dieser ist hier entlang des Durchmessers des Basiskörpers 10, insbesondere quer, vorzugsweise senkrecht, zur Längsachse des Gehäuses 100, vorzugsweise auch zur Längsachse 30d des Anschlusskörpers 30, unterbrochen. Der Anschlusskörper 30 setzt sich aus zwei Komponenten 30-1 und 30-2 zusammen. Als einen weiteren Unterschied besitzt das Gehäuse 100 bzw. der Anschlusskörper 30 nun zwei Laschen 33. Jeder der beiden Anschlusskörper 30-1 und 30-2 besitzt jeweils eine Lasche 33. Diese erstrecken sich entlang der Längsachse 30d. Es können somit zwei Anschlüsse, beispielsweise für die Anode und die Kathode einer LED 40 bereitgestellt werden.

In den bisher beschriebenen Figuren 1.a bis 7.a sind einige Ausführungsformen gezeigt, bei denen nur das Gehäuse 100 ohne ein Funktionselement 40 dargestellt ist. Dagegen illustrieren die Figuren 7.b bis 7.d nun Ausführungsformen mit einem einzelnen Funktionselement 40 oder mit einer Vielzahl von Funktionselementen 40 in einem Gehäuse 100.

Das Funktionselement 40 befindet sich nach einem Einbau in das Gehäuse 100 oder einem Aufsetzen auf der Oberseite 10a des Basiskörper 10, insbesondere auf dem Boden der ersten Vertiefung 11, im direkten Kontakt mit dem Basiskörper 10. Das Funktionselement 40 kann beispielsweise auf den Basiskörper 10 aufgeklebt oder aufgelötet werden. Als Lote werden vorzugsweise bleifreie Weichlote verwendet. Der Kleber ist vorzugsweise ein leitfähiger Kleber, wie ein mit Silber angereicherter Epoxidharz. Somit wird über einen direkten Kontakt auch ein Kontakt über einen Kleber, Lot oder ein Bindemittel verstanden.

Figur 7.b zeigt eine Ausführungsform, bei der eine Vielzahl von Funktionselementen 40, hier von beispielhaft vier LEDs 40, in einem einzelnen Reflektor 11 oder in einer einzelnen ersten Vertiefung 11 angeordnet sind. Die vier LEDs 40 sind durch eine gemeinsame Anode A und eine gemeinsame Kathode K gespeist und werden somit gemeinsam angesteuert. Sie werden vorzugsweise durch die beiden Laschen 33 des segmentierten Anschlusskörpers 30-1 und 30-2 bereitgestellt.

Figur 7.c zeigt eine Ausführungsform, bei der eine Vielzahl von Funktionselementen 40, hier von beispielhaft drei LEDs 40, in einem einzelnen Reflektor 11 oder einer einzelnen ersten Vertiefung 11 angeordnet sind. Der Anschlusskörper 30 ist hier beispielhaft in vier Anschlüsse 30-1 bis 30-4 segmentiert. Die drei LEDs 40 können getrennt angesteuert werden. Beispielsweise werden drei getrennte Anoden A und eine gemeinsame Kathode K durch die Segmente 30-1 bis 30-4 des Anschlusskörpers 30 bereitgestellt.

Figur 7.d zeigt eine Ausführungsform, bei der eine Vielzahl von Funktionselementen 40, hier von beispielhaft vier LEDs 40, in einer Vielzahl von Reflektoren 11 angeordnet sind. Es werden hier vier Reflektoren 11 im Basiskörper 10 bereitgestellt. Jedem Reflektor 11 ist wenigstens eine LED 40 zugeordnet. Die vier LEDs 40 können getrennt angesteuert werden. Beispielsweise können vier getrennte Anoden A durch die vier Segmente 30-1 bis 30-4 des Anschlusskörpers 30 bereitgestellt werden und eine gemeinsame Kathode K durch die Oberseite 10a des Basiskörper 10 oder durch einen Boden der Reflektoren 11.

Figuren 8.a und 8.b illustrieren nicht entsprechend der Erfindung ausgestaltete mögliche Kontaktierungen für ein einzelnes in einem Reflektor 11 positioniertes opto-elektronischen Funktionselements 40.

Das Funktionselement 40, insbesondere eine LED 40, ist in Figur 8.a mittels zweier Kontakte, nämlich Anode A und Kathode K, über seine Vorderseite und seine Rückseite kontaktierbar. Das Funktionselement 40 wird über einen Draht 50 (sogenanntes Wire- oder Draht-Bonding) mit den Zuleitungen bzw. dem Anschlusskörper 30 des Gehäuses 100 verbunden. Es wird dabei ein erster Anschluss durch den Anschlusskörper 30 bereitgestellt. Ein zweiter Anschluss wird durch die Oberseite 10a des metallischen Basiskörper 10, beispielsweise durch den Boden des Reflektors 11, bereitgestellt.

Figur 8.b zeigt die in Figur 8.a dargestellte Ausgestaltung mit einer auf dem Gehäuse 100 aufgebrachten Linse 60 als Abschlusselement 60. Die Linse 60 wird zum Beispiel durch das Aufsetzen eine Glaslinse oder durch das Applizieren eines Tropfens eines für den relevanten Wellenlängenbereich transparenten Materials, beispielsweise durch Silikon, bereitgestellt. Während die Figur 8.a eine Ausgestaltung eines Funktionselements 40 illustriert, welches über seine Vorder- und seine Rückseite kontaktierbar ist, zeigt Figur 8.b eine Ausgestaltung, bei der das Funktionselement 40 nur über seine Vorderseite kontaktierbar ist. Dazu ist der Anschlusskörper 30 hier in zwei Segmente 30-1 und 30-2 unterteilt. Ein erster Anschluss wird durch das links dargestellte Segment 30-1 bereitgestellt. Ein zweiter Anschluss wird durch rechts dargestellte Segment 30-2 bereitgestellt.

Abschließend zeigen die Figuren 9.a bis 9.c eine weitere Ausführungsform eines Gehäuses 100 mit einem am Mantel 13 des Basiskörpers 10 montierten Anschlusskörper 30. Hier ist der Anschlusskörper 30 beispielhaft als ein Kontaktstift 30 ausgeführt. Der Kontaktstift 30 ist ein längliches, metallisches Bauteil mit einem im Verhältnis zu seiner Länge deutlich reduzierten Querschnitt. Er ist ein nadel-oder nagelartiges Bauteil. Der Kontaktstift 30 wird, insbesondere zumindest abschnittsweise, I-förmig oder als ein im Wesentlichen gerader Stift bereitgestellt. Unter einem Kontaktstift 30 wird auch ein metallischer Draht verstanden. Der Durchmesser des Kontaktstifts 30 liegt im Allgemeinen bei etwa 0,1 mm² bis etwa 16 mm², bevorzugt bis etwa 3 mm², besonders bevorzugt bis etwa 0,8 mm².

Der Kontaktstift oder Anschlusskörper 30 ist mantel- oder randseitig an dem Basiskörper 10 befestigt. Die Glasschicht 20 oder 22 ist in dieser Variante des Gehäuses 100 an der Außenseite des Mantels 13 positioniert. Die Glasschicht 20 bedeckt den Mantel 13 nur abschnittsweise. Der Basiskörper 10 erstreckt sich nach unten hin über die Glasschicht 20 hinaus. Der Kontaktstift oder Anschlusskörper 30 befindet sich in oder innerhalb der Glasschicht 20 oder ist in diese zumindest abschnittsweise eingebettet. Er besitzt eine Länge, die größer ist als die Höhe der Glasschicht 20. In einem oberen Bereich ist der Anschlusskörper 30 vollständig über seinen Umfang von der Glasschicht 20 umgeben. Dagegen liegt der Anschlusskörper 30 in einem unteren Abschnitt vollständig frei. An der Außenseite der Glasschicht 20 ist ein rohrförmiger Abschnitt oder eine Hülse 16 positioniert. Die Hülse 16 erstreckt sich vollständig über den Umfang der Glasschicht 20 oder den Umfang des Gehäuses 100. Die Hülse 16 ist vorzugsweise eine metallische Hülse, zum Beispiel aus Edelstahl. Dadurch ist es möglich, die Außenseite des Gehäuses 100 potentialfrei bereitzustellen. Es wird durch die Hülse 16 ein potentialfreier Außenleiter oder eine Abschirmung gebildet.

Die zwei Lagen aus Basiskörper 10 und Hülse 16 sind hier nicht übereinander sondern nebeneinander angeordnet. Im Querschnitt ist zu erkennen, dass eine Art I-förmiger Glasverbund gebildet wird. Es wird eine Art Ring-in-RingSystem um den Basiskörper 10 herum gebildet. Dabei stellt die verbindende Glasschicht 20 oder 22 einen ersten Ring und die Hülse 16 einen zweiten Ring dar. Sie sind zusammen um den Basiskörper 10 herum angeordnet. Die Glasschicht 20 oder 22 und die Hülse 16 erstrecken sich hier vollständig und/oder kontinuierlich über den Umfang des Basiskörpers 10. Der Querschnitt des Gehäuses 100 ist hier beispielhaft rund, insbesondere oval, dargestellt. Der Querschnitt kann aber kreisförmig.oder eckig sein.

Figur 9.c entspricht der Figur 9.b. Zusätzlich ist jedoch auf der Oberseite 10a des Basiskörpers 10 noch eine Linse als Abschlusselement 60 angeordnet. Diese ist mittels der Befestigung oder Halterung 61 beabstandet von seiner Oberseite 10a an dem Basiskörper 10 befestigt. Die Halterung 61 ist zum Beispiel bereitgestellt durch einen weiteren rohrförmigen Abschnitt oder eine weitere Hülse. Die Halterung 61 ist hier auf der Oberseite der Hülse 16 aufgesetzt.

Die Figuren 10.a bis 10.c zeigen eine gegenüber den Figuren 9.a bis 9.c modifizierte Ausführungsform eines 1-lagigen Gehäuses 100. Zum einen ist der Querschnitt des Gehäuses 100 nicht mehr oval sondern kreisförmig. Zudem schließen der Basiskörper 10 und der Anschlusskörper 30 nicht mehr mit der Oberseite der Hülse 16 und der Oberseite der Glasschicht 20 ab. Die beiden erstrecken sich entlang der Längsachse des Gehäuses 100 zu der Oberseite hin und zu der Unterseite hin über die Hülse 16 und die Glasschicht 20 hinaus. Dadurch sind diese einfach zu kontaktieren. Figur 10.c zeigt eine Blick auf die Oberseite des Gehäuses 100 ohne die Bauteile 60 und 61. Der Basiskörper 10 und/oder der Anschlusskörper 30 erstrecken sich etwa 1 mm bis etwa 10 mm, vorzugsweise bis etwa 5 mm, über die Unterseite der Hülse 16 hinaus. Vorzugsweise liegt die Höhe und/oder der Durchmesser der Hülse 16 in einem Bereich von etwa 3 mm bis etwa 10 mm.

Die Figuren 11.a bis 11.c zeigen eine weitere modifizierte Ausführungsform eines 1-lagigen Gehäuses 100. In dieser Ausgestaltung sind zwei Anschlusskörper 30 vorgesehen. Somit können, in Verbindung mit dem Basiskörper 10, zum Beispiel zwei LEDs 40 getrennt angesteuert werden. Der Basiskörper 10 und die zwei Anschlusskörper 30 erstrecken sich zur Oberseite hin über die Glasschicht 20 hinaus. Sie schließen aber mit der Hülse 16 ab. Der Basiskörper 10 ist in dem Beispiel 2-teilig ausgeführt. Er wird durch einen oberen Körper und einen unteren Körper bereitgestellt. Zwischen dem unteren Körper oder Abschnitt des Basiskörpers 10 und den beiden Anschlusskörpern 30 ist noch ein weitere Isolation 23, zum Beispiel durch Glas, vorgesehen.

Die in den Figuren 9.a bis 11.c dargestellten Gehäuse 100 sind insbesondere geeignet für Stecksockelanwendungen. Denn der sich nach unten erstreckenden Basiskörper 10 und der oder die sich nach unten erstreckende(n) Anschlusskörper 30 kann bzw. können zum Anschließen einfach in einen Sockel, welcher zum Beispiel die Spannungsversorgung bereitstellt, eingesteckt werden. Die ist zum Beispiel für die Anwendung einer LED als Glühlampe geeignet.

### Bezugszeichenliste:

- 10: Basiskörper
- 10a: Oberseite des Basiskörpers
- 10b: Unterseite des Basiskörpers
- 10c: Mittelachse oder Zentralachse des Basiskörpers
- 11: Erste Vertiefung oder Reflektor im Basiskörper
- 12: Zweite Vertiefung oder Aufnahmebereich für den Anschlusskörper im Basiskörper
- 13: Mantel oder Rand des Basiskörpers
- 13-1: Äußerer oder außen liegender Mantel oder Mantelabschnitt des Basiskörper
- 13-2: Innerer oder innen liegender Mantel oder Mantelabschnitt des Basiskörpers
- 14: Montagebereich für ein Funktionselement
- 15: Isolation oder isolierende Schicht
- 16: Hülse oder Hülle

- 20: Glasschicht oder Glas zum Verbinden und Isolieren
- 21: Erster Schenkel der Glasschicht
- 22: Zweiter Schenkel der Glasschicht
- 23: Isolation oder weitere Glasschicht

- 30: Anschlusskörper
- 30a: Oberseite des Anschlusskörpers
- 30b: Unterseite des Anschlusskörpers
- 30d: Längsachse des Anschlusskörpers
- 30-1 bis 30-4: Segmente des Anschlusskörpers
- 31: Durchgangsbereich oder Öffnung oder Reflektor im Anschlusskörper
- 32: Anschlussbereich, insbesondere für einen Bonddraht, am Anschlusskörper
- 33: Anschlusslasche oder Lasche zum Verbinden im Anschlusskörper
- 34: Aufnahmebereich für ein optisches Bauelement oder ein Abschlusselement im Anschlusskörper

- 40: Funktionselement oder LED
- 50: Verbindungsmittel oder Draht oder Bonddraht
- 60: Abschlusselement oder optisches Bauelement oder Linse
- 61: Halterung für das Abschlusselement

- 100: Gehäuse

- A: Anode
- B: Kathode

## Patentansprüche

1. Gehäuse (100) zur Aufnahme eines opto-elektronischen Funktionselements (40), insbesondere einer LED (40), aus
- einem aus Metall ausgebildeten Basiskörper (10) mit einer Oberseite (10a), die zumindest abschnittsweise einen Montagebereich (14) für wenigstens ein opto-elektronisches Funktionselement (40) definiert, so dass der Basiskörper (10) einen Kühlkörper für wenigstens ein opto-elektronisches Funktionselement (40) bildet, einer Unterseite (10b) und einem Mantel (13, 13-1, 13-2); und
- wenigstens einem aus Metall ausgebildeten Anschlusskörper (30, 30-1 bis 30-4) für wenigstens ein opto-elektronisches Funktionselement (40), welcher zumindest mittels einer Glasschicht (20) mit dem Basiskörper (10) verbunden ist,
- wobei zumindest die Oberseite (10a) des Basiskörpers (10) wenigstens eine erste Vertiefung (11) mit einem Boden, welcher den Montagebereich (14) für zumindest ein opto-elektronisches Funktionselement (40) bereitstellt, aufweist,
der Anschlusskörper (30, 30-1 bis 30-4) auf der Oberseite (10a) des Basiskörpers (10) angeordnet ist,
wobei der Anschlusskörper (30, 30-1 bis 30-4) einen Durchgangsbereich (31) für eine von zumindest einem opto-elektronischen Funktionselement (40) emittierte und/oder zu empfangende Strahlung bereitstellt, der sich zumindest abschnittsweise über den Umfang der ersten Vertiefung (11) und/oder den Montagebereich (14) für zumindest ein opto-elektronisches Funktionselement (40) erstreckt,
und wobei das Gehäuse (100) im Wesentlichen anorganisch ausgebildet ist, wobei der Basiskörper (10) eine Oberseite (10a) und eine Unterseite (10b) aufweist, wobei ein Mantel des Basiskörpers (1) eine seitliche Wand beschreibt, welche die Oberseite (10a) mit der Unterseite (10b) verbindet,
wobei die Oberseite (10a) des Basiskörpers (10) wenigstens eine zweite Vertiefung (12) aufweist, die sich zumindest abschnittsweise über den Umfang der ersten Vertiefung (11) erstreckt, so dass der Mantel (13, 13-1, 13-2) des Basiskörpers (10) zumindest durch einen äußeren Mantel (13-1) und einen inneren Mantel (13-2) gebildet wird,
wobei eine Innenseite des Durchgangsbereichs (31) des Anschlusskörpers (30, 30-1 bis 30-4) an den inneren Mantel des Basiskörpers (10) angrenzt,
und wobei die zweite Vertiefung (12) einen Aufnahmebereich für den Anschlusskörper (30, 30-1 bis 30-4) bereitstellt.

2. Gehäuse (100) nach Anspruch 1, **dadurch gekennzeichnet, dass**
die Glasschicht (20) zumindest abschnittsweise zwischen der Oberseite (10a) des Basiskörpers (10) und einer Unterseite (30b) des Anschlusskörpers (30, 30-1 bis 30-4) angeordnet ist.

3. Gehäuse (100) nach einem der vorstehenden Ansprüche, **dadurch gekennzeichnet, dass**
der Anschlusskörper (30, 30-1 bis 30-4) segmentiert ist, so dass eine Vielzahl von Anschlüssen für wenigstens ein auf dem Basiskörper positioniertes opto-elektronisches Funktionselement bereitstellbar ist,
wobei vorzugsweise die Segmente (30-1 bis 30-4) des Anschlusskörpers (30) voneinander beabstandet und/oder durch die Glasschicht (20) elektrisch isoliert sind.

4. Gehäuse (100) nach einem der vorstehenden Ansprüche, **dadurch gekennzeichnet, dass**
der Anschlusskörper (30, 30-1 bis 30-4) sich zumindest abschnittsweise über den Basiskörper (10) hinaus erstreckt und wenigstens eine Lasche (33) zum Verbinden bildet, die und/oder
in dem Basiskörper (10) und/oder in dem Anschlusskörper (30, 30-1 bis 30-4) wenigstens ein Montagebereich (32) für ein Verbindungsmittel (50), vorzugsweise einen Bonddraht (50), bereitgestellt ist.

5. Gehäuse (100) nach einem der vorstehenden Ansprüche, **dadurch gekennzeichnet, dass**
die erste Vertiefung (11) einen Durchmesser besitzt, der ausgehend von dem Boden der ersten Vertiefung (11), auf dem wenigstens ein opto-elektronisches Funktionselement (40) positionierbar ist, in Richtung einer Oberseite der ersten Vertiefung (11), vorzugsweise kontinuierlich, zunimmt und/oder
der Durchgangsbereich (31) einen Durchmesser besitzt, der ausgehend von einer Unterseite des Durchgangsbereichs (31) in Richtung einer Oberseite des Durchgangsbereichs (31), vorzugsweise kontinuierlich, zunimmt.

6. Gehäuse (100) nach einem der vorstehenden Ansprüche **dadurch gekennzeichnet, dass** eine Innenseite der ersten Vertiefung (11) in dem Basiskörper (10) und/oder eine Innenseite des Durchgangsbereichs (31) in dem Anschlusskörper (30, 30-1 bis 30-4) zumindest abschnittsweise reflektierende Eigenschaften hat und die erste Vertiefung (11) in der Oberseite (10a) des Basiskörpers (10) und/oder der Durchgangsbereich (31) in dem Anschlusskörper (30, 30-1 bis 30-4) einen Reflektor für die von einem opto-elektronischen Funktionselement (40) emittierte und/oder zu empfangende Strahlung bildet.

7. Opto-elektronisches Bauteil, umfassend ein Gehäuse (100) nach einem der vorstehenden Ansprüche und wenigstens ein strahlungsemittierendes und/oder strahlungsempfangendes opto-elektronisches Funktionselement (40), insbesondere eine LED (40), welches in dem Gehäuse (100) angeordnet ist.

8. Beleuchtungseinrichtung, welche wenigstens ein Gehäuse (100) nach einem der vorstehenden Ansprüche oder wenigstens ein opto-elektronisches Bauteil nach vorstehendem Anspruch beinhaltet.

9. Matrix umfassend eine Vielzahl von Gehäusen (100) nach einem der vorstehenden Ansprüche

10. Verfahren zur Herstellung eines opto-elektronischen Funktionselementgehäuses (100), vorzugsweise gemäß einem der vorstehenden Ansprüche, insbesondere für eine LED (40), umfassend
- Bereitstellen wenigstens eines aus Metall ausgebildeten Basiskörpers (10) mit einer Oberseite (10a), welche zumindest abschnittsweise einen Montagebereich (14) für wenigstens ein opto-elektronisches Funktionselement (40) definiert, so dass der Basiskörper (10) einen Kühlkörper für wenigstens ein opto-elektronisches Funktionselement (40) bildet,
- Bereitstellen wenigstens eines aus Metall ausgebildeten Anschlusskörpers (30, 30-1 bis 30-4) für wenigstens ein opto-elektronisches Funktionselement (40) und zumindest eines Glases zwischen dem Basiskörper (10) und dem Anschlusskörper (30, 30-1 bis 30-4) zum Verbinden des Anschlusskörpers (30, 30-1 bis 30-4) mit dem Basiskörper (10),
- Zusammenfügen des Basiskörpers (10), des Anschlusskörpers (30, 30-1 bis 30-4) und des Glases und
- Erwärmen des Glases insoweit, dass dieses eine Viskosität besitzt und/oder erreicht, bei der es anhaftet und aus dem Basiskörper (10) und dem Anschlusskörper (30, 30-1 bis 30-4) ein Verbund bildbar ist,
- Abkühlen des Glases, so dass der Basiskörper (10) und der Anschlusskörper (30, 30-1 bis 30-4) zumindest mittels einer aus dem abgekühlten Glas gebildeten Glasschicht (20) einen stoffschlüssigen Verbund bilden,
- und wobei zumindest in der Oberseite (10a) des Basiskörpers (10) wenigstens eine erste Vertiefung (11) mit einem Boden, der den Montagebereich (14) für zumindest ein opto-elektronisches Funktionselement (40) bereitstellt, eingebracht wird,
wobei der Basiskörper (10) eine Oberseite (10a) und eine Unterseite (10b) aufweist, wobei ein Mantel des Basiskörpers (1) eine seitliche Wand beschreibt, welche die Oberseite (10a) mit der Unterseite (10b) verbindet,
wobei die Oberseite (10a) des Basiskörpers (10) wenigstens eine zweite Vertiefung (12) aufweist, die sich zumindest abschnittsweise über den Umfang der ersten Vertiefung (11) erstreckt, so dass der Mantel (13, 13-1, 13-2) des Basiskörpers (10) zumindest durch einen äußeren Mantel (13-1) und einen inneren Mantel (13-2) gebildet wird,
wobei eine Innenseite des Durchgangsbereichs (31) des Anschlusskörpers (30, 30-1 bis 30-4) an den inneren Mantel des Basiskörpers (10) angrenzt,
und wobei die zweite Vertiefung (12) einen Aufnahmebereich für den Anschlusskörper (30, 30-1 bis 30-4) bereitstellt.

## Claims

1. A package (100) for accommodating an optoelectronic functional element (40), in particular an LED, comprising:
- a base body (10) made of metal, having an upper surface (10a) which defines a mounting area (14) for at least one optoelectronic functional element (40) at least in sections thereof, so that said base body (10) forms a heat sink for at least one optoelectronic functional element (40), and having a lower surface (10b), and a lateral surface (13, 13-1, 13-2); and
- at least one connecting body (30, 30-1 to 30-4) made of metal, for at least one optoelectronic functional element (40) which is joined to the base body (10) at least by one glass layer (20);
- wherein at least the upper surface (10a) of the base body (10) has at least one first depression (11) with a bottom that provides the mounting area (14) for at least one optoelectronic functional element (40);
wherein the connecting body (30, 30-1 to 30-4) is arranged on the upper surface (10a) of the base body (10);
wherein the connecting body (30, 30-1 to 30-4) has a transmission zone (31) for radiation emitted and/or to be received by at least one optoelectronic functional element (40), which transmission zone extends over the range of the first depression (11) and/or the mounting area (14) for at least one optoelectronic functional element (40), at least over sections thereof; and wherein the package (100) is a substantially inorganic package, wherein the base body (10) has an upper surface (10a) and a lower surface (10b), wherein a lateral surface of the base body (10) forms a lateral wall surface connecting the upper surface (10a) with the lower surface (10b),
wherein the upper surface (10a) of the base body (10) has at least one second depression (12) which extends around the periphery of the first depression (11), at least in sections thereof, so that the lateral surface (13, 13-1, 13-2) of the base body (10) is defined by at least an outer lateral surface (13-1) and an inner lateral surface (13-2);
wherein an inner side of the transmission zone (31) of the connecting body (30, 30-1 to 30-4) adjoins the inner lateral surface of the base body (10),
and wherein the second depression (12) provides an accommodating region for the connecting body (30, 30-1 to 30-4).

2. The package according to claim 1, **characterised in that**
the glass layer (20) is disposed between the upper surface (10a) of the base body (10) and a lower surface (30b) of the connecting body (30, 30-1 to 30-4), at least in sections thereof.

3. The package (100) according to any one of the preceding claims, **characterised in that**
the connecting body (30, 30-1 to 30-4) is segmented, so that a plurality of connections can be provided for at least one optoelectronic functional element placed on the base body;
wherein preferably the segments (30-1 to 30-4) of the connecting body (30) are spaced from each other and/or are electrically insulated from each other by the glass layer (20).

4. The package (100) according to any one of the preceding claims, **characterised in that**
the connecting body (30, 30-1 to 30-4) extends beyond the base body (10) at least in sections thereof and forms at least one connection tab (33); and/or
at least one mounting area for a connecting means (50), preferably for a bonding wire (50), is provided in the base body (10) and/or in the connecting body (30, 30-1 to 30-4).

5. The package (100) according to any one of the preceding claims, **characterised in that**
the first depression (11) has a diameter that increases preferably continuously starting from the bottom of the first depression (11) on which at least one optoelectronic functional element (40) can be placed towards an upper side of the first depression (11); and/or
the transmission zone (31) has a diameter which increases preferably continuously starting from a lower side of the transmission zone (31) towards an upper side of the transmission zone (31).

6. The package (100) according to any one of the preceding claims, **characterised in that** an inner surface of the first depression (11) in the base body (10) and/or an inner surface of the transmission zone (31) in the connecting body (30, 30-1 to 30-4) has reflecting properties at least in sections thereof, and that the first depression (11) in the upper surface (10a) of the base body (10) and/or the transmission zone (31) in the connecting body (30, 30-1 to 30-4) defines a reflector for the radiation emitted and/or to be received by an optoelectronic functional element (40),

7. An optoelectronic component, comprising a package (100) according to any one of the preceding claims, and at least one radiation emitting and/or radiation receiving optoelectronic functional element (40), in particular an LED (40), which is arranged in said package (100).

8. An illumination device, comprising at least one package (100) according to any one of the preceding claims, or at least one optoelectronic component according to the preceding claim.

9. An array, comprising a plurality of packages (100) according to any one of the preceding claims.

10. A method for producing an optoelectronic functional element package (100), preferably according to any one of the preceding claims, in particular for an LED (40), comprising:
- providing at least one base body (10) made of metal, having an upper surface (10a) which defines a mounting area (14) for at least one optoelectronic functional element (40), at least in sections thereof, so that the base body (10) forms a heat sink for at least one optoelectronic functional element (40);
- providing at least one connecting body (30, 30-1 to 30-4) made of metal for at least one optoelectronic functional element (40), and at least one glass between the base body (10) and the connecting body (30, 30-1 to 30-4) for joining the connecting body (30, 30-1 to 30-4) to the base body (10);
- combining the base body (10), the connecting body (30, 30-1 to 30-4), and the glass; and
- heating the glass until it has and/or reaches a viscosity at which it adheres, such that a an assembly can be formed from the base body (10) and the connecting body (30, 30-1 to 30-4);
- cooling the glass, so that the base body (10) and the connecting body (30, 30-1 to 30-4) form a material bond through at least one glass layer (20) formed of the cooled glass;
- and wherein at least one first depression (11) is introduced into at least the upper surface (10a) of the base body (10), the depression having a bottom which provides the mounting area (14) for at least one optoelectronic functional element (40);
wherein the base body (10) has an upper surface (10a) and a lower surface (10b), wherein a lateral surface of the base body (10) forms a lateral wall surface connecting the upper surface (10a) with the lower surface (10b),
wherein the upper surface (10a) of the base body (10) has at least one second depression (12) which extends around the periphery of the first depression (11) at least in sections thereof, so that the lateral surface (13, 13-1, 13-2) of the base body (10) is defined by at least an outer lateral surface (13-1) and an inner lateral surface (13-2);
wherein an inner side of the transmission zone (31) of the connecting body (30, 30-1 to 30-4) adjoins the inner lateral surface of the base body (10);
and wherein the second depression (12) provides an accommodating region for the connecting body (30, 30-1 to 30-4).

## Revendications

1. Logement (100) pour recevoir un élément fonctionnel optoélectronique (40), en particulier une DEL (40), constitué de
- un corps de base (10) formé de métal avec un côté supérieur (10a) qui définit au moins partiellement une zone de montage (14) pour au moins un élément fonctionnel optoélectronique (40), de sorte que le corps de base (10) forme un dissipateur thermique pour au moins un élément fonctionnel optoélectronique (40), avec un côté inférieur (10b) et une enveloppe (13, 13-1, 13-2) ; et
- au moins un corps de raccordement (30, 30-1 à 30-4) formé de métal pour au moins un élément fonctionnel optoélectronique (40), lequel est relié au moins au moyen d'un revêtement vitreux (20) au corps de base (10),
- dans lequel au moins le côté supérieur (10a) du corps de base (10) présente au moins un premier évidement (11) avec un fond qui prévoit la zone de montage (14) pour au moins un élément fonctionnel optoélectronique (40),
le corps de raccordement (30, 30-1 à 30-4) est agencé sur le côté supérieur (10a) du corps de base (10),
dans lequel le corps de raccordement (30, 30-1 à 30-4) prévoit une zone de passage (31) pour un rayonnement émis et/ou à recevoir par au moins un élément fonctionnel optoélectronique (40), laquelle s'étend au moins partiellement par-dessus le périmètre du premier évidement (11) et/ou la zone de montage (14) pour au moins un élément fonctionnel optoélectronique (40),
et dans lequel le logement (100) est formé de manière essentiellement inorganique, dans lequel le corps de base (10) présente un côté supérieur (10a) et un côté inférieur (10b), dans lequel une enveloppe du corps de base (1) décrit une paroi latérale qui relie le côté supérieur (10a) au côté inférieur (10b),
dans lequel le côté supérieur (10a) du corps de base (10) présente au moins un deuxième évidement (12) qui s'étend au moins partiellement par-dessus le périmètre du premier évidement (11), de sorte que l'enveloppe (13, 13-1, 13-2) du corps de base (10) soit formée au moins d'une enveloppe extérieure (13-1) et d'une enveloppe intérieure (13-2),
dans lequel un côté intérieur de la zone de passage (31) du corps de raccordement (30, 30-1 à 30-4) est contigu à l'enveloppe intérieure du corps de base (10),
et dans lequel le deuxième évidement (12) prévoit une zone de réception pour le corps de raccordement (30, 30-1 à 30-4).

2. Logement (100) selon la revendication 1, **caractérisé en ce que**
le revêtement vitreux (20) est agencé au moins partiellement entre le côté supérieur (10a) du corps de base (10) et un côté inférieur (30b) du corps de raccordement (30, 30-1 à 30-4).

3. Logement (100) selon l'une des revendications précédentes, **caractérisé en ce que**
le corps de raccordement (30, 30-1 à 30-4) est segmenté, de sorte qu'une pluralité de raccordements peut être prévue pour au moins un élément fonctionnel optoélectronique positionné sur le corps de base,
dans lequel les segments (30-1 à 30-4) du corps de raccordement (30) sont de préférence espacés les uns des autres et/ou électriquement isolés via le revêtement vitreux (20).

4. Logement (100) selon l'une des revendications précédentes, **caractérisé en ce que**
le corps de raccordement (30, 30-1 à 30-4) s'étend au moins partiellement par-dessus le corps de base (10) et forme au moins une bride (33) pour relier, qui et/ou
dans le corps de base (10) et/ou dans le corps de raccordement (30, 30-1 à 30-4) au moins une zone de montage (32) est prévue pour un moyen de liaison (50), de préférence un fil de liaison (50).

5. Logement (100) selon l'une des revendications précédentes, **caractérisé en ce que**
le premier évidement (11) possède un diamètre qui, partant du fond du premier évidement (11) sur lequel au moins un élément fonctionnel optoélectronique (40) peut être positionné, augmente en direction d'un côté supérieur du premier évidement (11), de préférence en continu, et/ou
la zone de passage (31) possède un diamètre qui, partant d'un côté inférieur de la zone de passage (31) en direction d'un côté supérieur de la zone de passage (31), augmente, de préférence en continu.

6. Logement (100) selon l'une des revendications précédentes, **caractérisé en ce qu'**un côté intérieur du premier évidement (11) dans le corps de base (10) et/ou un côté intérieur de la zone de passage (31) dans le corps de raccordement (30, 30-1 à 30-4) présente au moins partiellement des propriétés réfléchissantes et le premier évidement (11) dans le côté supérieur (10a) du corps de base (10) et/ou la zone de passage (31) dans le corps de raccordement (30, 30-1 à 30-4) forme un réflecteur pour le rayonnement émis et/ou à recevoir par un élément fonctionnel optoélectronique (40).

7. Composant optoélectronique, comprenant un logement (100) selon l'une des revendications précédentes et au moins un élément fonctionnel optoélectronique (40) émettant un rayonnement et/ou recevant un rayonnement, en particulier une DEL (40), lequel est agencé dans le logement (100).

8. Dispositif d'éclairage, lequel comporte au moins un logement (100) selon l'une des revendications précédentes et au moins un composant optoélectronique selon la revendication précédente.

9. Matrice comprenant une pluralité de logements (100) selon l'une des revendications précédentes.

10. Procédé de fabrication d'un logement d'élément fonctionnel optoélectronique (100), de préférence selon l'une des revendications précédentes, en particulier pour une DEL (40), comprenant les étapes consistant à
- prévoir au moins un corps de base (10) formé de métal avec un côté supérieur (10a) qui définit au moins partiellement une zone de montage (14) pour au moins un élément fonctionnel optoélectronique (40), de sorte que le corps de base (10) forme un dissipateur thermique pour au moins un élément fonctionnel optoélectronique (40),
- prévoir au moins un corps de raccordement (30, 30-1 à 30-4) formé de métal pour au moins un élément fonctionnel optoélectronique (40) et au moins un verre entre le corps de base (10) et le corps de raccordement (30, 30-1 à 30-4) pour relier le corps de raccordement (30, 30-1 à 30-4) au corps de base (10),
- assembler le corps de base (10), le corps de raccordement (30, 30-1 à 30-4) et le verre et
- chauffer le verre jusqu'à ce que celui-ci possède et/ou atteigne une viscosité telle qu'il adhère et qu'à partir du corps de base (10) et du corps de raccordement (30, 30-1 à 30-4) une liaison puisse être formée,
- refroidissement du verre de sorte que le corps de base (10) et le corps de raccordement (30, 30-1 à 30-4) forment une liaison matérielle au moins au moyen d'un revêtement vitreux (20) formé à partir du verre refroidi,
- et dans lequel est amené au moins dans le côté supérieur (10a) du corps de base (10) au moins un premier évidement (11) avec un fond qui prévoit la zone de montage (14) pour au moins un élément fonctionnel optoélectronique (40),
dans lequel le corps de base (10) présente un côté supérieur (10a) et un côté inférieur (10b), dans lequel une enveloppe du corps de base (1) décrit une paroi latérale qui relie le côté supérieur (10a) au côté inférieur (10b),
dans lequel le côté supérieur (10a) du corps de base (10) présente au moins un deuxième évidement (12) qui s'étend au moins partiellement par-dessus le périmètre du premier évidement (11), de sorte que l'enveloppe (13, 13-1, 13-2) du corps de base (10) soit formée au moins d'une enveloppe extérieure (13-1) et d'une enveloppe intérieure (13-2),
dans lequel un côté intérieur de la zone de passage (31) du corps de raccordement (30, 30-1 à 30-4) est contigu à l'enveloppe intérieure du corps de base (10),
et dans lequel le deuxième évidement (12) prévoit une zone de réception pour le corps de raccordement (30, 30-1 à 30-4).
